(19) Europäisches Patentamt
European Patent Office
Office européen des brevets

(11) **EP 2 292 421 A1**

(12) **EUROPEAN PATENT APPLICATION**
published in accordance with Art. 153(4) EPC

(43) Date of publication:
**09.03.2011 Bulletin 2011/10**

(51) Int Cl.:
**B32B 5/18** (2006.01)   **B32B 7/02** (2006.01)
**B32B 37/06** (2006.01)   **C08J 9/28** (2006.01)

(21) Application number: **09762486.0**

(22) Date of filing: **09.06.2009**

(86) International application number:
**PCT/JP2009/060546**

(87) International publication number:
**WO 2009/151056 (17.12.2009 Gazette 2009/51)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **10.06.2008 JP 2008152233**

(71) Applicant: **Daicel Chemical Industries, Ltd.
Kita-ku
Osaka-shi
Osaka 530-0001 (JP)**

(72) Inventor: **YAMATO, Yo
Himeji-shi
Hyogo 671-1283 (JP)**

(74) Representative: **Grünecker, Kinkeldey,
Stockmair & Schwanhäusser
Anwaltssozietät
Leopoldstrasse 4
80802 München (DE)**

(54) **LAYERED PRODUCT HAVING POROUS LAYER AND FUNCTIONAL LAYERED PRODUCT MADE WITH THE SAME**

(57) The present invention provides a layered product having a porous layer made mainly of a polymer on a base, and a process for producing the same; and a functional layered product wherein a pattern of a functional material, such as an conductive material, is formed onto a light-transmitting base using the layered product having the porous layer, and a process for producing the functional layered product. A layered product comprising a base and a porous layer on at least one surface of the base, wherein the porous layer is constituted of a composition containing a polymer as a main component, the porous layer has micropores having an average pore diameter of 0.01 to 10 $\mu$m, and has a porosity of 30 to 85%, the composition constituting the porous layer has a glass transition temperature of 20°C or higher, and the porous layer is a layer which is convertible to a transparent layer by a heat treatment through disappearance of the micropores. A conductive pattern is formed on the porous layer surface of the layered product, and then the resultant layered product is subjected to a heat treatment to cause the micropores in the porous layer to disappear, thereby converting the porous layer to a transparent layer.

Fig. 3

Magnification; ×100

×100

1 mm

**Description**

TECHNICAL FIELD

The present invention relates to a layered product having a porous layer made mainly of a polymer on a base, and a process for producing the same; and a functional layered product using the layered product having the porous layer, and a process for producing the same. The layered product having the porous layer of the present invention exhibits an excellent printability due to micropores in the porous layer. When the layered product is subjected to a heat treatment after printing is made thereon so as to cause the micropores in the porous layer to disappear, thereby making this layer transparent, the resultant product is useful as a substrate material in wide scopes including an electromagnetic wave controlling material such as an electromagnetic wave shield or an electromagnetic wave absorbent, a circuit substrate, an antenna, and a heat sink plate.

BACKGROUND ART

A layered product having a porous layer made mainly of a polymer on a base, and a process for producing the same are disclosed, for example, in JP 2003-313356 A, JP 2005-162885 A, JP 2007-126638 A, and JP 2007-246876 A.

A product wherein a functional layer, such as a conductor layer, a dielectric layer, a semiconductor layer, an insulator layer or a resistor layer, is formed on a surface of a light-transmitting base can be used as an electromagnetic wave controlling material such as an electromagnetic wave shield or an electromagnetic wave absorbent, a circuit substrate, an antenna, or a heat sink plate. More specifically, the product can be used as an electromagnetic wave shielding material, or a circuit substrate for supplying electricity in a display instrument wherein the product need to be transparent, such as a CRT (cathode ray tube), a PDP (plasma display panel), a liquid display, or an organic EL display.

As one of the above-mentioned examples, an electromagnetic wave shielding material will be described.

In recent years, with an increase of the use of various electric facilities or electric appliance facilities, electromagnetic interference (EMI) has been rapidly increasing. It is pointed out that EMI causes malfunctions or troubles of the surrounding electronic or electric instruments, and further gives health problems to operators of these instruments. For this reason, about electronic or electric instruments, the intensity of electromagnetic wave emission therefrom is required to be controlled within a standard or regulation range. Among displays included in electronic or electric instruments, such as a CRT (cathode ray tubes), a PDP (plasma display panel), a liquid display, and an organic EL display, the PDP gives a large generation amount of electromagnetic wave; thus, about the PDP, electromagnetic wave is required to be more intensely shielded. In a PDP, a light-transmitting film on which wiring is formed in a lattice form is set on the front surface thereof in order to shield the electromagnetic wave.

An electromagnetic wave shielding material is disclosed in, for example, publications described below.

JP 1-278800 A(1989) or JP 5-323101 A(1993) discloses an electromagnetic wave shielding material having, on a transparent base thereof, a thin-film electro-conductive thin layer formed by vapor deposition of a metal or a metal oxide. However, when the electro-conductive layer is made as thin as the layer can attain transparency, the surface resistance of the electro-conductive layer becomes too large so as to cause a problem that the shielding effect is declined. Moreover, the use of the vapor deposition technique requires an expensive production apparatus, and generally gives poor productivity. Thus, a problem that costs for the production increase is caused.

JP 5-327274 A(1993) or JP 5-269912 A(1993) discloses an EMI shielding material wherein a highly electro-conductive fiber is embedded in a transparent base. However, the fiber diameter of the electro-conductive fiber, which is 35 $\mu$m (in paragraph [0014] of JP 5-327274 A) or 76 $\mu$m (in paragraph [0048] of JP 5-269912 A), is too large; therefore, the fiber is unfavorably seen. Thus, the EMI shielding material is unsuitable for being used as a display.

Japanese Patent No. 3388682 (2003) discloses a process for producing a film for display having an electromagnetic wave shielding property, the process comprising the steps of: laminating a metal foil onto a transparent plastic base through an adhesive layer, and subjecting the laminated metal foil to chemical etching to form a metallic mesh to produce the film. According to this process, a film for display having an improved electromagnetic wave shielding effect is obtained since the metal foil is used. However, for the etching of the metal foil, a so-called long photolithographic step (which includes resist-film-laminating, exposure to light, development, chemical etching, and resist-film-peeling) is required. Thus, an expensive production apparatus is necessary, and the production efficiency is poor because of a long and complicated production step. Therefore, a problem that production costs increase remains. Moreover, in order to improve adhesiveness between the metal foil and the transparent plastic base, the laminating surface of the metal foil is made rough; thus, after the etching, the surface of the transparent plastic base (the area contacting the roughened laminating surface of the metal foil) is irregular, so that the surface of the base is whitened by scattered reflection. In order to cause the base to express transparency, it is necessary to apply an adhesive or the like onto the base surface so as to make the surface smooth. For such a step, the production costs further increase.

Patent Document 1: JP 2003-313356 A
Patent Document 2: JP 2005-162885 A
Patent Document 3: JP 2007-126638 A
Patent Document 4: JP 2007-246876 A
Patent Document 5: JP 1-278800 A
Patent Document 6: JP 5-323101 A
Patent Document 7: JP 5-327274 A
Patent Document 8: JP 5-269912 A
Patent Document 9: Japanese Patent No. 3388682
Patent Document 10: International Publication WO 2007/097249

DISCLOSURE OF THE INVENTION

PROBLEMS TO BE SOLVED BY THE INVENTION

As described above, known electromagnetic wave shielding materials have problems that the performance thereof is insufficient or production costs therefor are high.

About not only the above-mentioned electromagnetic wave shielding materials but also other products, at the time of forming a functional layer, such as a conductor layer, a dielectric layer, a semiconductor layer, an insulator layer or a resistor layer, onto a surface of a base, a case where the functional layer is formed to be patterned is considerably more difficult than a case where the functional layer is not patterned. This matter is evident also from a complicated chemical etching step in the above-mentioned Japanese Patent No. 3388682. Particularly when the pattern is made fine, the difficulty further increases.

Further, International Publication WO 2007/097249 discloses that in order to make a porous layer transparent, a porous layer including-layered product wherein wiring is formed is wetted with a solvent to cause the porous layer to swell and soften, and to cause a void structure in the porous layer to disappear (paragraphs [0228] to [0232]). However, after the porous layer is caused to swell and soften, it is necessary to subject the solvent to a drying treatment; thus, the series of steps are complicated, and large production costs are required. Moreover, when the solubility of the porous layer in the used solvent is high, the porous layer itself is unfavorably dissolved so that the wiring pattern formed on the porous layer is not easily kept.

An object of the present invention is to provide a layered product having a porous layer on a base, wherein the porous layer is made mainly of a polymer and is converted to a transparent layer by a heat treatment; and a process for producing the layered product. More specifically, an object of the present invention is to provide a layered product that has the porous layer and is suitable for forming a pattern of a functional material, such as an electro-conductive material, easily onto a light-transmitting base; and a process for producing the layered product.

Another object of the present invention is to provide a functional layered product using the layered product having the porous layer; and a process for producing the functional layered product. More specifically, another object of the present invention is to provide a functional layered product wherein a pattern of a functional material, such as an electro-conductive material, is formed onto a light-transmitting base using the layered product having the porous layer; and a process for producing the functional layered product.

MEANS FOR SOLVING THE PROBLEMS

The present invention includes the followings:

(1) A layered product comprising a base and a porous layer on at least one surface of the base, wherein the porous layer is constituted of a composition containing a polymer as a main component, the porous layer has micropores having an average pore diameter of 0.01 to 10 $\mu$m, and has a porosity of 30 to 85%, the composition constituting the porous layer has a glass transition temperature of 20°C or higher, and the porous layer is a layer which is convertible to a transparent layer by a heat treatment through disappearance of the micropores.

The composition which constitutes the porous layer is a composition that softens and deforms at a temperature that is the glass transition temperature (Tg) of the composition or higher, is lower than the heat resistant temperature of the base, and is lower than the decomposition temperature of the composition (containing the polymer as the main component, and other optional component (s)) which constitutes the porous layer. Therefore, it is preferred that the composition constituting the porous layer has a glass transition temperature of, for example, 280°C or lower, preferably 200°C or lower, or 130°C or lower although the preferred temperature depends on the kind of the base.

The heat treatment for converting the porous layer to a transparent layer can be conducted at a temperature that is the glass transition temperature of the composition constituting the porous layer or higher, is lower than the heat resistant temperature of the base, and is lower than the decomposition temperature of the composition constituting the porous layer. In other words, the upper limit of the temperature for the heat treatment is lower than a lower temperature out of the heat resistant temperature of the base and the decomposition temperature of the composition constituting the porous layer.

In order to conduct the heat treatment stably, the decomposition temperature (decomposition starting temperature) of the composition constituting the porous layer is higher than the glass transition temperature of the composition constituting the porous layer essentially by 15°C or more, preferably by 30°C or more, more preferably by 50°C or more. As the temperature difference between the both temperatures is larger, a stabler heat treatment can be conducted. Accordingly, the upper limit of the temperature difference, which is not particularly limited, is generally 200°C since the polymer component is decomposed in a temperature region higher than the glass transition temperature (Tg) thereof by 200°C or more (Tg + 200°C) in many cases.

The heat treatment causes the composition constituting the porous layer to soften and deform so that the micropores disappear. As a result, the porous layer is converted to a transparent layer. Without use of a solvent, the porous layer is converted to the transparent layer by only the heat treatment.

(2) The layered product according to the above (1), wherein the base is a light-transmitting base selected from the group consisting of a transparent resin film, a transparent glass plate, and a transparent ceramic substrate.

(3) The layered product according to the above (1) or (2), wherein the composition, which constitutes the porous layer, further contains a crosslinking agent and/or a plasticizer. The crosslinking agent is substantially in an unreacted state in the porous layer, in order to convert the porous layer to a transparent layer.

The addition of the crosslinking agent causes a change (rise or fall) in the glass transition temperature of the composition constituting the porous layer. Thus, the glass transition temperature of the composition can be adjusted. Further, the addition of the plasticizer usually causes a fall in the glass transition temperature of the composition constituting the porous layer. Thus, the glass transition temperature of the composition can be adjusted. When the glass transition temperature of the polymer component itself is high, it is effective for conducting, with stability, the heat treatment for converting the porous layer to a transparent layer in the present invention that the crosslinking agent and/or the plasticizer are/is added to the composition to lower the glass transition temperature.

(4) The layered product according to any one of the above (1) to (3), wherein the porous layer is a layer formed by:

casting a solution of a porous layer-forming material containing the polymer which is to constitute the porous layer into a film form onto the base; and then

immersing the resultant cast film in a coagulating liquid; and then
drying the resultant structure. In short, the porous layer is a layer formed by a so-called phase separation method. The treatment for the drying at this time is conducted at a temperature lower than the glass transition temperature of the composition which constitutes the porous layer.

(5) The layered product according to any one of the above (1) to (4), wherein at least one selected from the group consisting of a conductor layer, a dielectric layer, a semiconductor layer, an insulator layer, a resistor layer, and a precursor layer of any one of these layers is/are further formed on the surface of the porous layer by a printing technique.

In the layered product according to any one of the above (1) to (5), the porous layer has a thickness of, for example, 0.1 to 100 μm.

In the layered product according to any one of the above (1) to (5), no interfacial peeling is caused between the base and the porous layer when examined in a tape peeling test according to the following method:

a method in which a masking tape having a width of 24 mm [Film Masking Tape No. 603 (#25)] manufactured by Teraoka Seisakusho Co., Ltd. is adhered onto the surface of the porous layer of the layered product to give an adhered length of 50 mm from one end of the tape; the adhered tape is bonded thereon under pressure by means of a roller having a diameter of 30 mm at a load of 200 gf; and then a tensile tester is used to pull out the other end of the tape at a peeling speed of 50 mm/minute, thereby performing T-form peeling.

(6) A process for producing the layered product according to any one of the above (1) to (4), comprising:

casting a solution of a porous layer-forming material containing a polymer which is to constitute the porous layer into a film form onto the base; and then
immersing the resultant cast film in a coagulating liquid; and then

drying the resultant structure.

The treatment for the drying at this time is conducted at a temperature lower than the glass transition temperature of the composition which constitutes the porous layer.

(7) The process for producing the layered product according to the above (6), wherein the solution of the porous layer-forming material is cast into the film form onto the base, and then the resultant cast film is kept in an atmosphere having a relative humidity of 70 to 100% and a temperature of 15 to 100°C for 0.2 to 15 minutes, and then the resultant cast film is immersed in the coagulating liquid.

(8) A process for converting the porous layer to a transparent layer, comprising:

subjecting the layered product according to any one of the above (1) to (5) to a heat treatment at a temperature that is the glass transition temperature of the composition constituting the porous layer or higher to cause the micropores in the porous layer to disappear.

The heat treatment is conducted at a temperature that is the glass transition temperature of the composition constituting the porous layer or higher, is lower than the heat resistant temperature of the base, and is lower than the decomposition temperature of the composition constituting the porous layer. In other words, the upper limit of the temperature for the heat treatment is lower than a lower temperature out of the heat resistant temperature of the base and the decomposition temperature of the composition constituting the porous layer. The heat treatment causes the composition constituting the porous layer to soften and deform so that the micropores disappear. As a result, the porous layer is converted to a transparent layer. Without use of a solvent, the porous layer is converted to the transparent layer by only the heat treatment.

(9) A process for producing a functional layered product comprising a base, a transparent layer containing a polymer as a main component on the base, and a functional layer formed on the transparent layer and selected from the group consisting of a conductor layer, a dielectric layer, a semiconductor layer, an insulator layer, and a resistor layer, the process comprising:

forming, on the surface of the porous layer of the layered product according to any one of the above (1) to (4), a layer selected from the group consisting of the conductor layer, the dielectric layer, the semiconductor layer, the insulator layer, the resistor layer, and a precursor layer of these layers; and
subjecting the resultant layered product to a heat treatment at a temperature that is the glass transition temperature of the composition constituting the porous layer or higher to cause the micropores in the porous layer to disappear, thereby converting the porous layer to a transparent layer.

The heat treatment is conducted at a temperature that is the glass transition temperature of the composition constituting the porous layer or higher, is lower than the heat resistant temperature of the base, and is lower than the decomposition temperature of the composition constituting the porous layer. In other words, the upper limit of the temperature for the heat treatment is lower than a lower temperature out of the heat resistant temperature of the base and the decomposition temperature of the composition constituting the porous layer. The heat treatment causes the composition constituting the porous layer to soften and deform so that the micropores disappear. As a result, the porous layer is converted to a transparent layer. Without use of a solvent, the porous layer is converted to the transparent layer by only the heat treatment.

Each of the precursor layers of these layers means, for example, a layer that can be converted to a conductor layer, a dielectric layer, a semiconductor layer, an insulator layer or a resistor layer by a heat treatment or the like after the precursor layer is formed.

(10) The process for producing the functional layered product according to the above (9), wherein the functional layer is patterned.

When the composition constituting the porous layer has a fusing temperature lower than the decomposition temperature thereof, it is preferred that the heat treatment is conducted at a temperature lower than the fusing temperature of the composition constituting the porous layer. When the porous layer composition is melted, the micropores disappear so that the porous layer is converted to a transparent layer. However, when the porous layer composition is unfavorably melted, the pattern of the patterned functional layer formed on the porous layer is not easily maintained.

(11) A functional layered product comprising a base, a transparent layer containing a polymer as a main component on the base, and a functional layer formed on the transparent layer and selected from the group consisting of a conductor layer, a dielectric layer, a semiconductor layer, an insulator layer, and a resistor layer, wherein the functional layered product is obtained by:

forming, on the surface of the porous layer of the layered product according to any one of the above (1) to (4), a layer selected from the group consisting of the conductor layer, the dielectric layer, the semiconductor layer, the insulator layer, the resistor layer, and a precursor layer of these layers; and

subjecting the resultant layered product to a heat treatment at a temperature that is the glass transition temperature of the composition constituting the porous layer or higher to cause the micropores in the porous layer to disappear, thereby converting the porous layer to a transparent layer.

(12) The functional layered product according to the above (11), wherein the functional layer is patterned.

EFFECTS OF THE INVENTION

In the layered product having the porous layer of the present invention, the average pore diameter of the micropores in the porous layer and the porosity of the layer are each set in the specified range, so that the flexibility of the porous layer is excellent. Additionally, the porous layer is sufficient in strength and excellent in folding endurance and handleability since the porous layer is backed with the base.

Since the layered product having the porous layer of the present invention has the above-mentioned characteristics, the layered product is excellent in printability onto porous layer surface thereof so that a fine functional pattern made of a conductor material or the like can be printed thereon. Further, the composition constituting the porous layer has a glass transition temperature of 20°C or higher; therefore, when the composition is subjected to a heat treatment, the porous layer softens so that the micropores disappear. Thus, the porous layer can be converted to a transparent layer the film thickness of which is decreased. In word words, when a fine functional pattern is printed on the porous layer surface and subsequently the pattern-printed layered product is subjected to a heat treatment, a fine functional pattern can be obtained on the resultant transparent resin layer. It is generally difficult to print a fine pattern made of a conductor material or the like directly onto a transparent resin layer because the resin layer has denseness (the resin layer has a nature of being poor in cushioning performance, and being smooth). Against this point, therefore, the present invention has a great advantage.

As described above, the layered product having the porous layer of the present invention is used to make it possible to yield a functional layered product wherein a fine functional pattern made of a conductor material or the like is formed on a base by interposition of a transparent resin layer originating from the porous layer. When a light-transmitting base is used as the base, a functional layered product that is transparent as a whole can be obtained. The resultant functional layered product can be broadly used as a substrate material including an electromagnetic wave controlling material such as an electromagnetic wave shield or an electromagnetic wave absorbent, a circuit substrate, an antenna, and a heat sink plate.

According to the present invention, through simple steps of printing a fine functional pattern onto the surface of the porous layer, and subjecting, after the printing, the resultant layered product to a heat treatment, it is possible to yield, at low production costs, a functional layered product wherein a functional pattern is formed on the base by interposition of a transparent resin layer originating from the porous layer.

BRIEF DESCRIPTION OF THE DRAWINGS

[Fig. 1] Fig. 1 is an electron microscopic photograph (with a magnification of 1,000) of a surface of the porous layer of the layered product obtained in Example 1.

[Fig. 2] Fig. 2 is an electron microscopic photograph (with a magnification of 1,000) of a cross section of the layered product obtained in Example 1.

[Fig. 3] Fig. 3 is an electron microscopic photograph (with a magnification of 100) of the electrical conductive pattern obtained in Example 7.

[Fig. 4] Fig. 4 is an electron microscopic photograph (with a magnification of 100) of the electrical conductive pattern obtained in Comparative Example 1.

MODES FOR CARRYING OUT THE INVENTION

First, the layered product having the porous layer of the present invention (hereinafter, the product may be referred to as the "porous layer-layered product") is described.

The layered product having the porous layer of the present invention comprises a base and a porous layer on at least one surface of the base, wherein the porous layer is constituted of a composition containing a polymer as a main component; the porous layer has micropores having an average pore diameter of 0.01 to 10 $\mu$m, and has a porosity of 30 to 85%; the composition constituting the porous layer has a glass transition temperature of 20°C or higher; and the porous layer is a layer which is convertible to a transparent layer by a heat treatment through disappearance of the micropores.

In the present invention, a large number of micropores in the porous layer may be independent micropores which is low in interconnection with each other, or interconnecting micropores. The micropores in the porous layer have an average pore diameter of from 0.01 to 10 $\mu$m. A porous layer having an average pore diameter less than 0. 01 $\mu$m is not easily produced by a phase separation method in the present invention. If the average pore diameter is more than 10 $\mu$m, it is difficult to control the pore diameter distribution uniformly in the porous layer.

The characteristic that the porous layer has the micropores in a large number can be observed and determined by observation through an electron microscope. In many cases, it can be determined whether or not there are small spherical rooms, circular pores, elliptic pores, or fibrous structures from the observation of the porous layer surface; and it can be verified that there are small rooms surrounded by spherical walls, or small rooms surrounded by fibrous structures from the observation of a section of the porous layer. A thin skin layer may be formed on the surface of the porous layer, or the pores may be in an open state.

The porous layer is constituted of a composition containing a polymer as a main component. The composition has a glass transition temperature of 20°C or higher, preferably 30°C or higher, more preferably 40°C or higher. The composition which constitutes the porous layer is a composition that softens and deforms at a temperature that is the glass transition temperature of the composition or higher, is lower than the heat resistant temperature of the base, and is lower than the decomposition temperature of the composition (containing the polymer as the main component, and other optional component (s)) which constitutes the porous layer. For this reason, it is preferred that in connection with the upper limit of the glass transition temperature, which depends on the kind of the base, the composition constituting the porous layer, has a glass transition temperature of, for example 280°C or lower, preferably 200°C or lower, or 130°C or lower. The composition constituting the porous layer preferably has a glass transition temperature of 30°C or higher and 130°C or lower, more preferably has a glass transition temperature of 40°C or higher and 115°C or lower.

On the other hand, the base has a heat resistant temperature which is higher than the glass transition temperature of the composition constituting the porous layer, and has practical heat resistance at a temperature at which the composition constituting the porous layer softens and deforms.

In the porous layer-layered product of the present invention, no interfacial peeling is caused between the base and the porous layer when examined in a tape peeling test according to the following method:

a method in which a masking tape having a width of 24 mm [Film Masking Tape No. 603 (#25)] manufactured by Teraoka Seisakusho Co., Ltd. is adhered onto the surface of the porous layer of the layered product to give an adhered length of 50 mm from one end of the tape; the adhered tape is bonded thereon under pressure by means of a roller (oil-resistant hard rubber roller No. 10 manufactured by Holbein Art Materials Inc.) having a diameter of 30 mm at a load of 200 gf; and then a tensile tester is used to pull out the other end of the tape at a peeling speed of 50 mm/minute, thereby performing T-form peeling. In short, the above matter means that the base and the porous layer are layered directly onto each other at such an interlayer adhesion strength that no interfacial peeling is caused between the base and the porous layer in the above tape peeling test.

As described above, the porous layer-layered product of the present invention has a structure wherein the base and the porous layer are layered onto each other with the specified interlayer adhesion strength; thus, the layered product has flexibility and excellent pore properties while the layered product has appropriate rigidity. As a result, the handleability thereof is improved. The interlayer adhesion strength between the base and the porous layer can be adjusted by setting the kind of the materials that constitutes each of the layers, or physical properties of the interface between the layers.

The base may be a film (the film may includes a member that is generally called a sheet) made of a resin material having practical heat resistance at a temperature at which the composition constituting the porous layer softens and deforms, a glass plate, or a ceramic substrate. These members are each preferably a transparent base in the light of uses to which the invention is applied, which are to be described later.

The transparent base may include a completely transparent base, and further a so-called semitransparent base, which is a base far side of which is visible through the base from the near side. It is advisable to use a base having a total light transmittance of 30 to 100%. Light having some wavelengths is absorbed in transparent colored bases such as a polyimide film; thus, the transparent colored bases have a smaller total light transmittance than transparent colorless bases each made of polyethylene terephthalate (PET) or the like. As the thickness of the base is larger, the total light transmittance thereof is smaller.

Examples of the resin material which constitutes the base include plastic materials such as polyimide resins, polyamideimide resins, poly(ether sulfone) resins, poly(ether imide) resins, polycarbonate resins, poly(phenylene sulfide) resins, polyester resins, polyamide resins, polysulfone resins, cellulose resins, vinyl alcohol resins, poly(vinyl acetal) resins, acrylic resins, poly(ethylene terephthalate) resins, poly(ethylene naphthalate) resins, poly(butylene terephthalate) resins, fluorine resins, olefin resins, polyarylate resins. These materials may be used alone or in the form of a mixture of two or more thereof. Copolymers (graft copolymers, block copolymers, random copolymers and other copolymers) of the above resins may be used alone or in combination. Furthermore, a polymer containing, in main chain or a side chain, a skeleton (polymer chain) of any of the above-mentioned resins may be used. Specific examples of this type of the polymer include a polysiloxane-containing polyimide that contains skeletons of a polysiloxane and a polyimide in their main chain.

The base may be a monolayered base, or a composite film composed of plural layers that are made of the same material or different materials. The composite film may be a laminated film wherein plural films are laminated optionally using an adhesive or the like, or a film obtained by conducting coating, vapor deposition, sputtering or some other treatment.

When the porous layer is formed on only one surface of the base, a pressure-sensitive adhesive layer may be formed on the other surface. Furthermore, a protective film (releasing film) may be applied to the pressure-sensitive adhesive layer in order that the base can be more easily handled.

The resin base in the present invention is preferably a resin film that is not dissolved or intensely deformed, or is never or scarcely changed in any film quality when the solution of the porous layer-forming material (coating solution) containing the polymer that is to constitute the porous layer is applied onto a surface of the base.

The base in the present invention may be a commercially available film, examples of which include: "TEIJIN TETORON FILM", "MELINEX" and "MYLAR" manufactured by Teijin DuPont Films Japan Limited, and "LUMIRROR" manufactured by Toray Industries, Inc. as commercially available poly(ethylene terephthalate) resin (PET) films; "TEONEX" manufactured by Teijin DuPont Films Japan Limited as a commercially available poly(ethylene naphthalate) resin (PEN) film; and "NEOPULIM" manufactured by Mitsubishi Gas Chemical Company, Inc. as a commercially available polyimide resin film. Further, "HDN-20" manufactured by New Japan Chemical Co., Ltd. has been announced.

A film that is most versatilely used as the olefin resin film is a polypropylene film, and a commercially available product of which can be easily obtained. Besides, a film made of a cyclic olefin resin having a cyclic structure may be used. For example, a base obtained by making the following commercially available resin into a film may be used: "TPX" manufactured by Mitsui Chemicals, Inc., "ZEONOR" manufactured by Zeon Corporation, or "TOPAS" manufactured by Polyplastics Co., Ltd.

In addition to the above, the following are presented in expositions or the like: an article of a transparent heat-resistant film made of a poly(amide imide) resin and developed by Toyobo Co., Ltd.; an article of a heat-resistant transparent film (F film) that is developed by Gunze Limited; an article of a transparent and colorless aramid film that is developed by Toray Industries, Inc.; and a highly-heat-resistant transparent film "SILPLUS" developed by Nippon Steel Chemical Co. , Ltd. Such individual films may also be used.

The base may be subjected to a surface treatment, such as an easy-adhesion treatment, an antistatic treatment, a sandblast treatment (sand mat treatment), a corona discharge treatment, a plasma treatment, a chemical etching treatment, a water mat treatment, a flame treatment, an acid treatment, an alkali treatment, an oxidizing treatment, an ultraviolet radiation treatment, or a treatment using a silane coupling agent. A commercially available product subjected to such a surface treatment may be used. Examples of the base include a PET film subjected to an easy-adhesion treatment or an antistatic treatment, and a polyimide film subjected to a plasma treatment.

The above-mentioned surface treatments may be conducted in a combination of two or more thereof. For example, use may be made of a method of subjecting a base, at first, to any of a corona discharge treatment, a plasma treatment, a flame treatment, an acid treatment, an alkali treatment, an oxidizing treatment, an ultraviolet radiation treatment and others; and then subjecting the resultant to a treatment using a silane coupling agent. Depending on the kind of the base, the above method may make the treatment more intense than a single treatment with a silane coupling agent. The above method can be expected to produce a highly advantageous effect, in particular, for a polyimide base or the like. The silane coupling agent may be a product manufactured by Shin-Etsu Chemical Co., Ltd., or Japan Energy Corporation.

The thickness of the resin base is, for example, 1 to 300 $\mu$m, preferably 5 to 200 $\mu$m, more preferably 5 to 100 $\mu$m. If the thickness is too small, it is difficult to handle the base. By contrast, if the thickness is too large, the flexibility of the resin base may lower. The commercially available bases given as examples above include bases each having a thickness of 12 $\mu$m, 12.5 $\mu$m, 25 $\mu$m, 50 $\mu$m, 75 $\mu$m or 125 $\mu$m, or some other thickness. Any of the bases may be used.

The base other than the resin base may be a glass plate or a ceramic substrate. The material that constitutes the glass plate and the ceramic substrate is not particularly limited as far as interfacial peeling is not caused between the base material and the porous layer in the above-mentioned tape peeling test. The material may be appropriately selected in accordance with the material that constitutes the porous layer. Examples of the transparent glass plate include medium-duty glass plates, PYREX (registered trade name) glass plates, and quartz glass. An example of the transparent ceramic substrate is a transparent YAG ceramic material manufactured by Konoshima Chemical Co., Ltd.

The glass plate and the ceramic substrate may each be of a monolayer, or may be a composite composed of plural layers made of the same material or different materials. The composite may be a layered product wherein plural glass plates or ceramic substrates are laminated optionally using an adhesive or the like. The composite may be a composite obtained by undergoing coating, vapor deposition or sputtering, or some other treatment. When the porous layer is formed on only one surface of the glass plate or the ceramic substrate, a pressure-sensitive adhesive layer may be formed on the other surface. Furthermore, a protective film (releasing film) may be applied to the pressure-sensitive adhesive layer in order that the base can be easily handled.

Each of the glass plate and the ceramic substrate in the present invention is preferably a plate or a substrate that is not dissolved or intensely deformed, or is never or scarcely changed in any quality when a solution of a porous layer-forming material (coating solution) containing the polymer that is to constitute the porous layer is applied onto a surface of the base.

The glass plate and the ceramic substrate may each be subjected to a surface treatment, such as a roughening treatment, an easy-adhesion treatment, an antistatic treatment, a sandblast treatment (sand mat treatment), a corona discharge treatment, a plasma treatment, a chemical etching treatment, a water mat treatment, a flame treatment, an acid treatment, an alkali treatment, or an oxidizing treatment. A commercially available product subjected to such a surface treatment may be used. The base is, for example, a glass plate subjected to a sandblast treatment.

The thickness of each of the glass plate and the ceramic substrate is, for example, 20 to 5,000 $\mu$m, preferably 50 to 4,000 $\mu$m, more preferably 100 to 3,000 $\mu$m. If the thickness is too small, it is difficult to handle the base. By contrast, if the thickness is too large, the usage of the layered product having the base is limited.

The porous layer is constituted of a composition containing a polymer as a main component, and having a glass transition temperature of 20°C or higher. Examples of the polymer component constituting the porous layer include plastic materials such as polyimide resins, poly(amide imide) resins, poly(ether sulfone) resins, poly(ether imide) resins, polycarbonate resins, poly(phenylene sulfide) resins, polyester resins (such as polyethylene terephthalate resin, and polyethylene naphthalate resin), polyamide resins, polysulfone resins, polyacrylonitrile resins, cellulose resins, vinyl alcohol resins, poly(vinyl acetal) resins, poly(vinylformal) resins, poly(vinyl acetate) resins, acrylic resins. These polymer components may be used alone or in the form of a mixture of two or more thereof. Copolymers (graft copolymers, block copolymers, random copolymers and other copolymers) of the above resins may be used alone or in combination. Furthermore, a polymer containing, in main chain or a side chain, a skeleton (polymer chain) of any of the above-mentioned resins may be used. Specific examples of this type of the polymer include a polysiloxane-containing polyimide that contains skeletons of a polysiloxane and a polyimide in their main chain.

It is allowable to use, as a part of the polymer component constituting the porous layer, any of precursors of said polymer component such as a monomer component (starting material) or an oligomer for said polymer component, and a precursor before imidation and/or cyclization.

Particularly preferred examples of the polymer component constituting the porous layer include reactive poly(vinyl acetal) resins, which have flexibility and appropriate mechanical strength, and are high in adhesiveness to the base and are excellent in compatibility. Usually, poly(vinyl acetal) resins can each be produced by saponifying poly(vinyl acetate) to prepare poly(vinyl alcohol), and then causing the poly(vinyl alcohol) to react with an aldehyde compound. About poly(vinyl acetal) resins, physical and chemical properties thereof vary by the kind of the aldehyde used, the acetalization degree, and the ratios (composition ratios) of hydroxyl groups and vinyl acetate groups therein. Moreover, in accordance with the polymerization degree, various grades of poly (vinyl acetal) are obtained, which are different from each other in thermal and mechanical properties and solution viscosity. One species of poly(vinyl acetal) resins is poly(vinyl butyral).

Preferred are also poly(amide imide) resins, poly(phenylene sulfide) resins, poly(ethylene naphthalate), poly(vinyl formal) resins, and others. When the glass transition temperature of the polymer component itself is high, it is advisable to add a crosslinking agent and/or a plasticizer thereto, thereby lowering the glass transition temperature of the whole of the composition constituting the porous layer.

The thickness of the porous layer is, for example, 0.1 to 100 $\mu$m, preferably 0.5 to 70 $\mu$m, more preferably 1 to 50 $\mu$m. If the thickness is too small, it is difficult to produce the porous layer with stability, and moreover, the cushioning performance may lower, or the printability may lower. By contrast, if the thickness is too large, it is difficult to control the pore diameter distribution uniformly.

In the porous layer-layered product of the present invention, the base and the porous layer are layered onto each other at such an interlayer adhesion strength that no interfacial peeling is caused between the base and the porous layer in the above tape peeling test. Examples of the means for improving the adhesion between the base and the porous layer include a method of subjecting the side surface of the base, on which the porous layer is to be layered, to an appropriate surface treatment, such as a sandblast treatment (sand mat treatment), a corona discharge treatment, an acid treatment, an alkali treatment, an oxidizing treatment, an ultraviolet radiation treatment, a plasma treatment, a chemical etching treatment, a water mat treatment, a flame treatment, or a treatment using a silane coupling agent; a method that uses, as components that constitute respectively the base and the porous layer, a combination of materials capable of exhibiting good adhesiveness (affinity or compatibility) therebetween. The silane coupling agent may be a known silane coupling agent. About the above-mentioned surface treatments, a combination of two or more thereof may be conducted. Depending on the base, it is preferred to conduct a combination of a treatment using a silane coupling agent with any of the other treatments.

From the viewpoint of the adhesion between the base and the porous layer, for example, the following is preferred for the porous layer-layered product of the present invention:

the polymer component constituting the porous layer is at least one selected from the group consisting of polyimide resins, poly(amide imide) resins, poly(ether sulfone) resins, polyester resins, polyamide resins, cellulose resins, vinyl alcohol resins, poly(vinyl acetal) resins, poly(vinyl formal) resins, poly(vinyl acetate) resins, and acrylic resins; and

the light-transmitting base is a light-transmitting base selected from the group consisting of: a transparent resin film made of at least one resin material selected from polyimide resins, poly(amide imide) resins, poly(ether sulfone) resins, poly(ether imide) resins, polycarbonate resins, poly(phenylene sulfide) resins, polyester resins, polyamide resins, cellulose resins, vinyl alcohol resins, poly(vinyl acetal) resins, acrylic resins, poly(ethylene terephthalate) resins, poly(ethylene naphthalate) resins, poly(butylene terephthalate) resins, olefin resins and polyarylate resins; a transparent glass plate; and a transparent ceramic substrate.

The porous layer in the present invention has a large number of micropores, and the average pore diameter of the micropores (= the average pore diameter of the micropores inside the porous layer) is 0.01 to 10 $\mu$m, preferably 0.05 to 5 $\mu$m. A porous layer having an average pore diameter less than 0.01 $\mu$m is not easily produced by a phase separation method in the present invention. If the average pore diameter is more than 10 $\mu$m, it is difficult to control the pore diameter distribution uniformly in the porous layer.

The average rate of open area (porosity) inside the porous layer is, for example, 30 to 85%, preferably 40 to 85%, more preferably 45 to 85%. If the porosity is out of the above range, it may be difficult to give desired pore properties corresponding to the usage of the layered product. For example, when the porosity is too low, the cushioning performance may lower or the printability may lower. If the porosity is too high, the porous layer may be poor in strength or folding endurance. The rate of open area in the surface (surface open rate) of the porous layer is not particularly limited. When printing is made on the surface of the porous layer, an appropriate surface open rate may be preferable in order that the porous layer may be caused to exhibit an anchor effect to ensure the adhesion of the surface with an ink.

It is sufficient that the porous layer is formed on at least one surface of the base. The porous layer may be formed on both surfaces of the base. The formation of the porous layer makes it possible to yield a layered product with cushioning performance and the like. After a functional layer is formed by printing on the porous layer surface, the porous layer may be subjected to a treatment for transparentization. The functional layered product subjected to the transparentization may be used as a substrate material in wide scopes including an electromagnetic wave controlling material such as an electromagnetic wave shield or an electromagnetic wave absorbent, a circuit substrate, an antenna, and a heat sink plate.

In the present invention, the composition constituting the porous layer may further contain a crosslinking agent besides the above-mentioned polymer component. The addition of the crosslinking agent may cause a change (rise or fall) in the glass transition temperature of the composition constituting the porous layer, so that the glass transition temperature of the composition can be adjusted. In the porous layer, the crosslinking agent is substantially in an unreacted state until the heat treatment for transparentization that will be conducted later. In a case where the crosslinking agent reacts in the porous layer at a stage before the heat treatment for transparentization that will be conducted later, the porous layer is not easily subjected to the transparentization by the heat treatment. However, the crosslinking reaction is allowable as far as the transparentization of the porous layer by the heat treatment is not interfered. In a case where the addition of the crosslinking agent is performed and the crosslinking reaction is caused at an appropriate time, that is, at a time slightly after the heat treatment for the transparentization (slightly after the transparentization in the heat treatment stage for the transparentization) or at a stage after the heat treatment for the transparentization, it is possible to supply heat resistance, solvent resistance, chemical resistance, adhesion, coating strength and other properties to the transparent resin layer originating from the porous layer.

The supply of chemical resistance to the transparent resin layer originating from the porous layer is advantageous for the following reason: when the porous layer contacts a solvent, an acid, an alkali or the like in various use modes of the functional layered product of the present invention, the supply makes it possible that the layer can avoid interfacial peeling, swelling, dissolution, denaturation, or some other inconvenience. The method for causing the polymer and the crosslinking agent to react with each other may be a treatment with heat, ultraviolet rays, visible rays, electron rays, radiation, or the like. The method is most generally a heat treatment at an appropriate temperature.

Here, the chemicals, which have a chance of the contact in various use modes of the functional layered product of the present invention, cannot be specified without reservation; specific examples thereof include (A) strongly polar solvents, such as dimethylsulfoxide (DMSO), N,N-dimethylformamide (DMF), N,N-dimethylacetamide (DMAc), N-methyl-2-pyrrolidone (NMP), 2-pyrrolidone, cyclohexanone, acetone, methyl acetate, ethyl acetate, ethyl lactate, acetonitrile, methylene chloride, chloroform, tetrachloroethane, and tetrahydrofuran (THF); (B) inorganic salts such as sodium hydroxide, potassium hydroxide, calcium hydroxide, sodium carbonate, and potassium carbonate; amines such as triethylamine; alkaline solutions, such as an aqueous solution or an organic solvent wherein an alkali such as ammonia is dissolved; (C) inorganic acids such as hydrogen chloride, sulfuric acid, and nitric acid; acidic solutions, such as an aqueous solution or an organic solvent wherein an acid, such as an organic acid having a carboxylic acid such as acetic acid or phthalic acid, is dissolved; and (D) any mixture of these chemicals.

The crosslinking agent is not particularly limited as far as it is an agent that is reactive with the polymer constituting the porous layer to cause crosslinking. Examples thereof include an epoxy resin, a melamine resin, a phenol resin, a urea resin, a guanamine resin, an alkyd resin, polyisocyanate compounds, dialdehyde compounds, and silane coupling agents. These crosslinking agents may be used alone or in combination of two or more thereof.

The epoxy resin includes various resin species, examples of which are glycidyl ether epoxy resins, such as bisphenol A type, bisphenol F type and other bisphenol type resins, and phenol novolak type, cresol novolak type and other novolak type resins; alicyclic epoxy resins; and modified resins of these resins. As commercially available products of epoxy resins, the following may be used: "ARALDITE" manufactured by Huntsman Advanced Materials, "DENACOL" manufactured by Nagase ChemteX Corporation, "CELLOXIDE" manufactured by Daicel Chemical Industries, Ltd., "EPOTOHTO" manufactured by Tohto Kasei Co., Ltd. and "jER" manufactured by Japan Epoxy Resins Co., Ltd.

Examples of the polyisocyanate include aromatic polyisocyanates such as tolylenediisocyanate (TDI), 4,4'-diphenylmethanediisocyanate (MDI), phenylenediisocyanate, diphenyldiisocyanate and naphthalenediisocyanate; aliphatic polyisocyanates such as hexamethylenediisocyanate (HDI) and lysinediisocyanate; and alicyclic polyisocyanates such as isophorone diisocyanate (IPDI), cyclohexane-1,4-diisocyanate, and hydrogenated MDI.

Even when the functional layered product of the present invention that has both of a transparent resin layer originating from the porous layer to which such a crosslinking agent is added and a functional layer contacts a strongly polar solvent, or a chemical agent such as an alkali or an acid, the transparent resin layer is not dissolved, not swelled to be deformed, or not subjected to any other denaturation at all, or can be restrained from being denatured to such a degree that the denaturation produces no influence on the use purpose or the usage. For example, for the usage of the layered product in which a period during which the transparent resin layer and the chemical agent contact each other is short, it is sufficient that chemical resistance is supplied thereto to such a degree that the layer does not denature within this period.

When a crosslinked structure is formed in the polymer in the transparent resin layer originating from the porous layer, not only the chemical resistance of the transparent resin layer but also the heat resistance thereof are improved in many cases. Furthermore, the strength of the transparent resin layer may increase or the adhesion strength to the base may become high when the crosslinked structure is formed in the polymer.

In the present invention, the composition constituting the porous layer may further contain a plasticizer. With the addition of the plasticizer, flexibility can be given to the porous layer. The addition of the plasticizer may cause a fall in the glass transition temperature of the composition constituting the porous layer. Thus, the glass transition temperature of the composition can be adjusted.

The plasticizer is not particularly limited as far as it is a plasticizer compatible with the polymer constituting the porous layer. Examples thereof include glycol plasticizers (such as triethylene glycol, diethyl butyrate, butyl butylphthalylglycolate (BPBG), and polyethylene glycol (PEG)), phosphate plasticizers (such as tricresyl phosphate (TCP)), phthalate plasticizers (such as dibutyl phthalate (DBP), and dioctyl phthalate (DOP)), sebacate plasticizers (such as dibutyl sebacate, and bis(2-ethylhexyl) sebacate (DOS)), aliphatic acid ester plasticizers (such as methyl acetylricinolate), phosphoric ester plasticizers (such as tricresyl phosphate), epoxidized plant oil plasticizers (such as epoxidized soybean oil, and epoxidized linseed oil), and other plasticizers (such as castor oil, chlorinated paraffin, and triacetin).

A preferred embodiment of the present invention is, when the base is a resin film, a porous layer-layered product wherein a porous layer is formed on a single surface or each surface of the base, the average pore diameter of micropores in the porous layer is 0.01 to 10 $\mu$m, the porosity of the layer is 30 to 85%, the thickness of the porous layer is 0.1 to 100 $\mu$m, and the thickness of the base is from 1 to 300 $\mu$m. Such porous layer-layered product can be produced by setting appropriately the materials constituting respectively the porous layer and the base, the thicknesses thereof, and production conditions (for example, humidification conditions before the cast structure is introduced into a coagulating liquid) or the like. The glass transition temperature of the composition constituting the porous layer can be appropriately adjusted by selecting an appropriate polymer and further adding a crosslinking agent and/or a plasticizer thereto.

The porous layer-layered product can be produced by, for example, the following methods:

a method comprising the steps of:

casting a solution of a porous layer-forming material containing a polymer which is to constitute the porous layer into a film form onto the base;
bringing the resultant cast film structure into contact with a coagulating liquid to convert the film into a porous layer; and then

drying the resultant structure as it is, thereby obtaining a layered product of the base and the porous layer;

a method comprising the steps of:

casting a solution of a porous layer-forming material containing a polymer which is to constitute the porous layer into a film form onto a support;
bringing the resultant cast film structure into contact with a coagulating liquid to convert the film into a porous layer;
transferring the resultant porous layer from the support onto a surface of the base; and subsequently
drying the resultant structure, thereby obtaining a layered product of the base and the porous layer. In the present invention, the above former method is preferably employed, as will be detailed hereinafter.

The process of the present invention for producing a porous layer-layered product is characterized by casting a solution of a porous layer-forming material containing a polymer which is to constitute the porous layer into a film form onto the base, introducing the resultant cast structure into a coagulating liquid, and then drying the resultant structure, thereby forming the porous layer onto at least one surface of the base to obtain the porous layer-layered product. According to this process, a wet phase inversion process is used to form the porous layer onto the base, and then the resultant structure is subjected, as it is, to drying; therefore, at the same time with the formation of the porous layer, the porous layer can be layered onto the base surface so as to adhere closely thereto. Thus, the production efficiency can be improved. Since the porous layer with a large number of micropores is flexible, the porous layer itself alone is not easily handled and the step of laminating the porous layer itself onto a base is difficult. However, in the producing process of the present invention, since the porous layer is layered at the same time with the formation of the porous layer, such problems can be avoided. As a result, it is possible to obtain, with ease, a porous layer-layered product wherein a porous layer having excellent pore properties and a base are directly layered onto each other.

The solution of the porous layer-forming material (which may be referred to as the porous layer-forming solution hereinafter) contains, for example, a polymer component that is a main material constituting the porous layer, and a water-soluble polar solvent, and optionally contains a crosslinking agent, a plasticizer, a water-soluble polymer and/or water.

The temperature of the coagulating liquid is not particularly limited, and may be set within the range of, for example, 0 to 100°C. If the temperature of the coagulating liquid is lower than 0°C, an effect of washing the solvent and others easily deteriorates. If the temperature of the coagulating liquid is higher than 100°C, the solvent or the coagulating liquid volatilizes so that the working environment is damaged. The coagulating liquid is preferably water from the viewpoint of low costs, safety, no toxicity and others. When water is used as the coagulating liquid, the temperature of water may be set within the range of about 5 to 60°C. The period during which the cast film structure is immersed in the coagulating liquid may be appropriately selected from periods during which the solvent and the water-soluble polymer are sufficiently washed. If the washing period is too short, the residue of the solvent may cause the porous structure to be broken in the drying step. If the washing period is too long, the production efficiency deteriorates, resulting in an increase in costs for the production. The washing period varies by the thickness of the porous layer, and others; thus, the period cannot be specified without reservation. However, the period may be set within the range of, for example, about 0.5 to 30 minutes.

It is preferred to cast the porous layer-forming solution into a film form onto the base, keep the resultant cast film in an atmosphere having a relative humidity of 70 to 100% and a temperature of 15 to 100°C for 0.2 to 15 minutes, and then immerse the resultant cast film in the coagulating liquid.

The addition of the water-soluble polymer or water to the porous layer-forming solution is effective for making the film structure porous in the form of a sponge. Examples of the water-soluble polymer include poly(ethylene glycol), poly(vinylpyrrolidone), poly(ethylene oxide), poly(vinyl alcohol), polyacrylic acid, polysaccharides and derivatives thereof, and any mixture of two or more of these polymers. These water-soluble polymers may be used alone or in combination of two or more thereof. In order to make the film structure porous, it is advisable that the weight-average molecular weight of the water-soluble polymer is 200 or more, preferably 300 or more, in particular preferably 400 or more (for example, a weight in the range of about 400 to about 200,000), and especially preferably 1,000 or more. The addition of water helps to adjust the pore diameters. For example, an increase in the addition amount of water to the porous layer-forming solution makes it possible to make the pore diameters large.

The water-soluble polymer is very effective for rendering the film structure a uniform porous structure in the form of a sponge. When the kind and the amount of the water-soluble polymer are varied, various porous structures can be obtained. For this reason, in order that desired pore properties can be given to the porous layer, the water-soluble polymer is used very suitably as an additive when the porous layer is formed.

When the amount of the water-soluble polymer is increased, the interconnection of the pores with each other tends to be enhanced. The strength tends to be declined with the enhancement of the interconnection. Thus, excessive addition of the water-soluble polymer is not preferred. Since the excessive addition requires the washing period to be made long, the excessive addition is not preferred, either. It is also possible not to use the water-soluble polymer.

Examples of the water-soluble polar solvent include dimethylsulfoxide, N,N-dimethylformamide, N,N-dimethylacetamide (DMAc), N-methyl-2-pyrrolidone (NMP), 2-pyrrolidone, and any mixture of these solvents. It is allowable to use a solvent having a dissolving capability corresponding to the chemical skeleton of a resin used as the above-mentioned polymer component (a good solvent for the polymer component).

The blend amounts of the individual components in the porous layer-forming solution are preferably set, based on the porous layer-forming solution, as follows:

5 to 40% by weight of the polymer component;
0 to 10% by weight of the water-soluble polymer;
0 to 10% by weight of water;
0 to 30% by weight of the crosslinking agent;
0 to 15% by weight of the plasticizer; and
60 to 95% by weight of the water-soluble polar solvent.

If the concentration of the polymer component is too low at this time, the thickness of the porous layer tends to become insufficient or desired pore properties tend not to be easily obtained. By contrast, if the concentration of the polymer component is too high, the porosity tends to become small. The concentration of the polymer component may be appropriately selected from the above-mentioned range so as to cause the porous layer-forming solution to have a viscosity appropriate for being applied. If the concentration of the water-soluble polymer is too high, the interconnection of the pores inside the film is enhanced so that the strength of the porous layer lowers. The addition amount of water may be used to control the pore diameters. When the addition amount of water is increased, the pore diameters can be made large.

It is desired to cast the porous layer-forming solution into a film form onto the base, keep the resultant cast film in an atmosphere having a relative humidity of 70 to 100% and a temperature of 15 to 100°C for 0.2 to 15 minutes, and then introduce the resultant film into a coagulating liquid made of a non-solvent for the polymer component. It appears that when the cast film is put in the humidified environment, moisture enters into the inside of the film from the film surface, so that phase separation of the polymer solution is efficiently promoted. Preferred conditions are conditions that the relative humidity is 90 to 100% and the temperature is 30 to 90°C, and more preferred conditions are conditions that the relative humidity is about 100% (for example, 95 to 100%) and the temperature is 40 to 80°C. If the water content in the air is smaller than the above range, the porosity may be insufficient.

According to the above-mentioned process, it is possible to form, for example, a porous layer having a large number of micropores having an average pore diameter of 0.01 to 10 $\mu$m with ease. As descried above, the diameter of the micropores, the porosity, and the surface open rate in the porous layer which constitutes the porous layer-layered product of the present invention, can each be adjusted to a desired value by appropriately selecting the kinds or amounts of the constituting components of the polymer solution, the humidity, the temperature, the period and others of flow-casting.

The coagulating liquid used in the phase inversion process may be any coagulating liquid as far as the liquid is a solvent for coagulating the polymer component. The coagulating liquid is appropriately selected in accordance with the kind of a polymer used as the polymer component. For example, when the polymer is a poly(amide imide) resin, the liquid may be a water-soluble coagulating liquid, for example, water; an alcohol such as methanol, ethanol, some other monohydric alcohol, glycerin or some other polyhydric alcohol; a water-soluble polymer such as polyethylene glycol; or any mixture of these liquids.

In the producing process of the present invention, the cast film structure is introduced into the coagulating liquid to form a porous layer onto a surface of the base, and then the resultant structure is subjected, as it is, to drying, thereby producing a layered product having a structure wherein the porous layer is layered directly onto the base surface. The drying is not particularly limited as far as the drying is conducted by a method capable of removing the solvent components such as the coagulating liquid. The drying may be drying under heating, or natural drying at a room temperature. The drying treatment at this time is conducted at a temperature lower than the glass transition temperature of the composition constituting the porous layer. In the drying treatment, attention should be paid to avoid a matter that the composition constituting the porous layer softens so that the micropores are lost. If the micropores are lost, the printability onto the porous layer is declined.

The method for the drying treatment is not particularly limited as far as the method makes it possible to control the layered product to a predetermined temperature; the method may be a hot air treatment, a hot roll treatment, or a method of putting the above resultant structure into a thermostat, an oven or the like. The atmosphere at the time of the drying treatment may be air, nitrogen, or an inert gas. Although the use of air is most inexpensive, an oxidation reaction may follow the treatment. For avoiding this, it is advisable to use nitrogen or an inert gas, and nitrogen is preferred from the viewpoint of costs. Conditions for the heating are appropriately set, considering productivity, physical properties of the porous layer and the base, and others. By subjecting the above resultant structure to drying, a layered product wherein a porous layer is formed directly onto the base surface can be obtained.

According to the producing process of the present invention, it is possible to obtain, with ease, a film having polymer porous layer(s) wherein a single surface or both surfaces of a base film are covered with the polymer porous layer(s), and the polymer porous layer(s) has/have a large number of micropores having an average pore diameter of 0.01 to 10 $\mu$m.

Since the porous layer-layered product of the present invention has the above-mentioned structure, the layered product can be used for various articles or purposes in wide fields. Specifically, when the pore properties of the porous layer are used as they are, the layered product exhibits an excellent printability that a functional material can be printed onto the porous layer. When the layered product is kept at the glass transition temperature of the composition constituting the porous layer or higher after the printing of the functional material, in order to cause the micropores to disappear and convert the porous layer into a transparent layer, the layered product can be used as a substrate material in wide scopes including an electromagnetic wave controlling material such as an electromagnetic wave shield or an electromagnetic wave absorbent, a circuit substrate, an antenna, and a heat sink plate.

Since the porous layer-layered product of the present invention is excellent in printability, a pattern is formed on the porous layer by printing and the resultant can be used. In this way, the porous layer-layered product is used as an ink-image-receiving sheet (printing medium); thus, the following will describe a printing technique in detail.

At present, many printing methods have been made practicable and used. Examples of such printing techniques include ink-jet printing, screen printing, dispenser printing, letterpress printing (flexography), sublimation printing, offset printing, laser printer printing (toner printing), intaglio printing (gravure printing), contact printing, and micro-contact printing. Constituting components of an ink used therein are not particularly limited, and examples thereof include a conductor, a dielectric, a semiconductor, an insulator, a resistor, and a colorant.

Advantages of a case where an electronic material is produced by printing are, for example, as follows: (1) the material can be produced through a simple process; (2) the process is an environment-friendly process, wherein the amount of wastes is small; (3) the material can be produced in a short time with a low energy consumption, and (4) initial investment costs can be largely reduced. In fact, however, the case is technically difficult since printing unprecedentedly high in minuteness and precision is required. Accordingly, about printing used in the production of electronic materials, not only the performance of a printing machine but also properties of an ink or an ink-image-receiving sheet produce a large effect on print results. In the porous layer-layered product of the present invention, the porous layer adheres closely to the base, and the fine porous structure of the porous layer can adhere closely to a printing plate without generating any gap therebetween because of the cushioning performance thereof. Additionally, the fine porous structure can absorb an ink, or can cause an ink to be precisely fixed therein. Therefore, the porous layer-layered product can attain printing unprecedentedly high in minuteness and precision. Thus, the porous layer-layered product is very favorably used. Furthermore, the porous layer adheres closely to the base; thus, the porous layer-layered product can ensure a strength sufficient for being handled. For example, the porous layer-layered product makes it possible to attain continuous printing in a roll-to-roll manner, and make a remarkable improvement in production efficiency.

When an electronic material is produced by printing, the above-mentioned methods may be used as a printing method therefor. Specific examples of the electronic material produced by printing include electromagnetic wave controlling materials such as an electromagnetic wave shield and an electromagnetic wave absorbent, a circuit substrate, an antenna, and a heat sink plate. More specific examples thereof include a liquid crystal display, an organic EL display, a field emission display (FED), an IC card, an IC tag, a solar cell, an LED element, an organic transistor, a condenser (capacitor), an electronic paper, a flexible battery, a flexible sensor, a membrane switch, a touch panel, and an EMI shield.

The method for producing the electronic material includes the step of printing an ink containing an electronic substance, such as a conductor, a dielectric, a semiconductor, an insulator or a resistor, onto a surface of the porous layer (substrate). For example, by printing an ink containing a dielectric onto a surface of the porous layer (substrate), a condenser (capacitor) can be formed. Examples of the dielectric include barium titanate, and strontium titanate. By printing an ink containing a semiconductor onto a surface of the porous layer, a transistor or the like can be formed. Examples of the semiconductor include pentacene, liquid silicon, fluorene-bithiophene copolymer (F8T2), and poly(3-hexylthiophene) (P3HT).

By printing an ink containing a conductor, wiring can be formed. Thus, a flexible substrate, a TAB substrate, an antenna or the like can be produced. Examples of the conductor include conductive inorganic particles of silver, gold, copper, nickel, ITO, carbon, or carbon nanotubes; and particles made of a conductive organic polymer such as polyaniline, polythiophene, polyacetylene or polypyrrole. The polythiophene may be poly(ethylenedioxythiophene) (PEDOT). These particles may be used as an ink in the form of a solution or colloid. Of these particles, conductor particles that are inorganic particles are preferred. Silver particles or copper particles are particularly preferred, especially from the viewpoint of the balance between electric properties and costs. The shape of the particles may be a spherical shape, a scaly (flake) shape, or the like. The particle size is not particularly limited. Use may be made of, for example, particles extending from particles having an average particle diameter of several micrometers to the so-called nanoparticles, which have an average particle diameter of several nanometers. These particles may be used in combination of different types of the particles. Hereinafter, a description will be made, giving a silver ink (silver paste), which is easily available, as an example of the conductive ink. However, the conductive ink is not limited thereto, and inks that are of different types may be used.

A silver ink generally contains, as constituting components thereof, silver particles, a surfactant, a binder, a solvent and others. Another example of a silver ink contains silver oxide particles using a nature that silver oxide is heated to be reduced. Said silver ink containing silver oxide particles is printed, and the resultant printed article is afterward heated and reduced to make silver wiring. Still another example of a silver ink contains an organosilver compound. Said silver ink containing an organosilver compound is printed and the resultant printed article is afterward heated and decomposed to make silver wiring. As the organosilver compound, a compound soluble in a solvent may be used. As the particles that constitute the silver ink, silver particles, silver oxide, and organosilver compound may be used alone or in combination. Particles different from each other in particle diameter may be used in combination. After the silver ink is used and printed, the temperature (calcination temperature) at the time of curing the ink may be appropriately selected in accordance with the composition of the ink, the particle diameter, and others. Usually, the temperature is within the range of about 100 to 300°C in many cases. Since the porous layer-layered product of the present invention is made of organic materials, the calcination temperature is preferably a relatively low temperature in order that deterioration can be avoided. However, in order to make the electric resistance of the wiring small, it is in general preferred that the ink is calcined at a high temperature. Thus, it is necessary to select an ink having an appropriate curing temperature and use the ink. As a commercially available product of such a silver ink, the following are known: products with a trade name "CA-2503" manufactured by Daiken Chemical Co. , Ltd.; with a trade name "NANO DOTITE XA9053" manufactured by Fujikura Kasei Co., Ltd.; with trade names "NPS" and "NPS-J" (average particle diameter: about 5 nm) manufactured by Harima Chemicals, Inc.; and with a trade name "FINESPHERE SVW102" (average particle diameter: about 30 nm) manufactured by Nippon Paint Co. , Ltd. It is preferred to select the particle diameter, the particle size distribution, and the blend ratio of the conductor or the like that is added to the ink, considering the balance between electric resistance and wiring adhesiveness that are required for a wiring substrate.

In the case of screen printing, an ink is not easily held on a screen if the viscosity of the ink is too low. Thus, it is preferred that the viscosity of the ink is somewhat high. Even when the particle diameter of particles contained in the ink is large, no problem is caused. If the particle diameter is small, it is preferred to decrease the solvent amount. Accordingly, the particle diameter is preferably about 0.01 to 10 $\mu$m.

The following will describe a advantageous application of the porous layer-layered product of the present invention, that is, a functional layered product using the porous layer-layered product. The functional layered product can be obtained by forming a functional layer onto the porous layer surface of the porous layer-layered product of the present invention, and then subjecting the resultant layered product to a heat treatment, thereby losing the pore structure of the porous layer to make the porous layer transparent.

In the porous layer-layered product of the present invention, highly minute and precise printing can be attained on the porous layer by effect of the pore properties of the porous layer. However, since the structure causes scattered reflection of visible rays, thereby being whitened and opaque, the usage of the porous layer-layered product is limited when the layered product is used as it is. Thus, by selecting a composition having a glass transition temperature of 20°C or higher as the composition constituting the porous layer, the pore structure of the porous layer is lost by a heat treatment, thereby restraining scattered reflection of visible rays so that the porous layer can be made transparent.

The conversion of the porous layer into a transparent layer is attained by heating the porous layer-layered product wherein a functional pattern that may be of various types is formed onto the porous layer surface, thereby softening the porous layer slightly, so as to cause the pore structure inside the porous layer to disappear.

The heat treatment at this time is conducted at a temperature that is the glass transition temperature of the composition constituting the porous layer or higher, is lower than the heat resistant temperature of the base, and is lower than the decomposition temperature of the composition constituting the porous layer. In other words, the upper limit of the temperature for the heat treatment is lower than a lower temperature out of the heat resistant temperature of the base and the decomposition temperature of the composition constituting the porous layer. The heat treatment causes the composition constituting the porous layer to soften and deform so that the micropores disappear. As a result, the porous layer is converted to a transparent layer. Without use of a solvent, the porous layer is converted to the transparent layer by only the heat treatment.

When the composition constituting the porous layer has a fusing temperature lower than the decomposition temperature thereof, it is preferred that the heat treatment is conducted at a temperature lower than the fusing temperature of the composition constituting the porous layer. If the heat treatment is conducted at the fusing temperature or higher, the porous layer composition is melted, whereby the micropores disappear so that the porous layer is converted to a transparent layer. However, when the porous layer composition is unfavorably melted, the pattern of the patterned functional layer formed on the porous layer is not easily maintained.

By selecting, as the base, a light-transmitting base having a heat resistant temperature higher than the glass transition temperature of the composition constituting the porous layer, and having practical heat resistance at a temperature at which the composition constituting the porous layer softens and deforms, it is possible to produce a functional layered product wherein a transparent resin layer is present on the light-transmitting base, and a functional pattern formed by printing is present on the resin layer. By making the porous layer transparent in this way, the resultant functional layered product can be used as various articles or purposes for which light-transmitting property is required, for example, a display material.

Herein, a description is made on evaluation of a transparency attained in the conversion of the porous layer into the transparent layer.

The index of the transparency of the transparent layer converted from the porous layer can be represented as the absolute value of the difference between the total light transmittance (%) of the used base itself and the total light transmittance (%) of the transparentized layered product (the base + the transparent layer), as shown by the following equation.

$$\text{Transparency (T) of the transparent layer} = |\text{Total light transmittance (Ts) of the base itself} - \text{Total light transmittance (Tst) of the layered product (the base + the transparent layer)}|$$

The reason why in the above equation, the absolute value of the difference between "Ts" and "Tst" is used is that the value of "Tst" may be larger than that of "Ts" in some cases. When fine irregularities are present on a surface of the base itself, it appears that the fine irregularities are made smooth by the existence of the transparent layer on the surface, whereby scattered reflection is restrained so that the value of "Tst" becomes larger than that of "Ts".

In the present invention, the value of the transparency (T) of the transparent layer is, for example, 0 to 30%, preferably 0 to 20%, more preferably 0 to 10%, in particular 0 to 5%. If the value of the transparency (T) of the transparent layer is more than 30%, the conversion of the porous layer into a transparent layer is unfavorably insufficient. In the evaluation of the degree of the attained transparency, it is necessary to measure the total light transmittance (%) of the layered product (the base + the transparent layer) at its region where a functional layer such as a conductor layer is not formed. The functional layer generally inhibits transmission of light rays. The total light transmittance may be measured by use of a haze meter, NDH-5000 W, manufactured by Nippon Denshoku Industries Co., Ltd. in accordance with JIS K7136.

The thickness of the resultant transparent layer is calculated on the basis of the thickness and the porosity of the porous layer.

$$\text{Thickness of the transparent layer} = \text{Thickness of the porous layer} \times (100 - \text{the porosity})/100$$

In the present invention, the thickness of the porous layer is 0.1 to 100 $\mu$m, and the porosity of the layer is 30 to 85%. Thus, the thickness of the transparent layer may range from 0.015 $\mu$m to 70 $\mu$m. It is advisable to determine a desired thickness of the transparent layer appropriately with reference to the preferred range of the thickness of the porous layer and the preferred range of the porosity thereof.

When the transparent resin layer originating from the porous layer is used in, for example, a wiring substrate, the resin layer can make the inspection of the wiring easy. Moreover, when the wiring substrate is fabricated into a device, the transparent resin layer makes the perception of a positional relationship between parts easy. From these matters and others, the transparent resin layer is advantageous since the layer gives excellent handleability. Moreover, when the base of the porous layer-layered product is constituted of a transparent and colorless base made of PET (polyethylene terephthalate), PEN (polyethylene naphthalate) or the like, the transparency of the region other than the wiring portion is very high after the porous layer is converted into the transparent layer. With such a functional layered product, wiring or a circuit can be formed onto a display screen itself; thus, a circuit substrate is omitted so that the display itself can be made thin, and further the structure is made simple, thereby decreasing costs.

When high transparency is required for the use of a display, it is preferred to select, as the material for the porous layer, a material that is convertible to a colorless and highly transparent resin layer by a heat treatment, and it is also preferred to make the thickness of the porous layer as small as possible. It is also preferred to select, as the base, a highly transparent base made of PET, PEN or the like.

The base of the porous layer-layered product is preferably a base having heat resistance permitting the base not to deform at a heat treatment temperature for making the porous layer transparent. When the base deforms, the dimensional stability required for a wiring substrate is unfavorably declined. Since the temperature at which the base can be used varies by the species of the base, the temperature cannot be specified without reservation; however, PET, PEN, polyimide or glass plate is preferable since the usable temperature thereof is relatively high.

For the base of the porous layer-layered product, PET is particularly suitable from the viewpoint of transparency, heat resistance, flexibility, handleability and costs. PEN is also suitable although the price thereof is somewhat high. Polyimide is also suitable although the price thereof is slightly higher. A glass plate is also suitable from the viewpoint of transparency, excellence in heat resistance, handleability and costs although the plate is poor in flexibility.

The upper limit of the temperature for the heat treatment for making the porous layer transparent varies among the bases, and cannot be specified without reservation. In the case of using, for example, PET for the base, it is advisable that the heating temperature is 200°C or lower, preferably 190°C or lower, in particular preferably 180°C or lower. In the case of using PEN or PPS (polyphenylene sulfide), it is advisable that the heating temperature is 300°C or lower, preferably 260°C or lower, in particular preferably 200°C or lower. In the case of using polyimide, it is advisable that the heating temperature is 400°C or lower, preferably 300°C or lower, in particular preferably 260°C or lower. In the case of using a glass plate, it is advisable that the heating temperature is 800°C or lower, preferably 300°C or lower, in particular preferably 260°C or lower. The period for the heat treatment varies in accordance with the components that constitute the porous layer and cannot be specified without reservation, either. It is advisable that the period is from 1 minute to 3 hours, preferably from about 3 minutes to about 1 hour. The heating may be conducted at a single stage or at two stages. In the case of using, for example, a functional material that can be calcined at low temperature, such as a silver ink, it is allowable to print the ink, calcine the ink and then raise the temperature of the resultant structure to subject the porous layer to a transparentization treatment, or perform the heating at a single stage at a temperature set to be applicable to both of the calcination of the ink and the transparentization treatment.

In the present invention, it is essential that the composition constituting the porous layer has a glass transition temperature of 20°C or higher. If the glass transition temperature is lower than the 20°C, the porous structure may be unfavorably changed even at a room temperature.

When the porous layer is made only of a polymer component, the glass transition temperature of the polymer is the glass transition temperature of the composition constituting the porous layer. When the porous layer is composed of a polymer and a crosslinking agent, the glass transition temperature of the two-component system is the glass transition temperature of the composition constituting the porous layer. In this case, the crosslinking agent may function as a plasticizer for the polymer to lower the glass transition temperature. By controlling the kind and the amount of the crosslinking agent, the glass transition temperature can be controlled to an appropriate temperature. When the porous layer contains a plasticizer, the glass transition temperature lowers. When the glass transition temperature is too high, it becomes necessary to set the porous layer to a high temperature in order to make the porous layer transparent; thus, the base may unfavorably deform or produce some other defect depending on the species thereof. It is very important to form a porous layer having a preferred glass transition temperature.

Patterned wiring made of a conductive material or the like may be formed on only a single surface of the porous layer. When the porous layer is present on each surface of the base, the wiring may be formed on each of the surfaces. When the wiring is formed on each of the surfaces, a via through which the wires on both surfaces are connected to each other may be formed as the need arises. The via hole may be formed by drilling, or by a laser. A conductor in the via holes may be made from a conductive paste, or made by plating.

It is also allowable to cover a wiring surface made from a conductive ink with plating or an insulator, and use the resultant. It is indicated that, in particular, in silver wiring, electromigration or ion migration is more easily caused than in copper wiring (Nikkei Electronics, 2002, 6, No. 17, p. 75). Thus, it is effective to cover the wiring surface made of a silver ink with plating in order to improve the reliability of the wiring. Examples of the plating include copper plating, gold plating, and nickel plating. The operation for the plating may be performed by a known method.

In the functional layered product of the present invention, a metallic plating layer and/or a magnetic plating layer may be layered on the wiring surface. The functional layered product may be referred to as a composite material in the present specification.

The metallic plating layer may be formed as, for example, a thin metallic coat on the wiring surface. Examples of the metal constituting the metallic plating layer include copper, nickel, silver, gold, tin, bismuth, zinc, aluminum, lead, chromium, iron, indium, cobalt, rhodium, platinum and palladium; and any alloy of these metals. The metallic plating layer may be a coat made of a various alloy containing an element other than a metal, such as nickel-phosphorus, nickel-copper-phosphorus, nickel-iron-phosphorus, nickel-tungsten-phosphorus, nickel-molybdenum-phosphorus, nickel-chromium-phosphorus, and nickel-boron-phosphorus. For the metallic plating layer, the above-mentioned metals may be used alone or in combination of two or more thereof. The layer may be a single layer, or composed of plural layers.

The material constituting a magnetic plating layer is not particularly limited as far as the material is a compound having magnetic properties. The material may be a ferromagnetic substance or a paramagnetic substance. Examples thereof include alloys, such as nickel-cobalt, cobalt-iron-phosphorus, cobalt-tungsten-phosphorus, and cobalt-nickel-manganese; compounds each having a moiety capable of generating a radical, such as a methoxyacetonitrile polymer; metal complex compounds, such as a charge transfer complex of decamethylferrocene; and organic magnetic substances, such as polyacrylonitrile which is a semi-graphitized carbonaceous material, and others.

Such a composite material may be produced by use of a known method as a method of forming a layer on the wiring surface in the present invention by using a metal or an organic compound.

The formation of the metallic plating layer may be performed by use of a known method such as electroless plating or electroplating. In the layered product of the present invention, electroless plating, which will be described later, is preferably used since the transparent layer originating from the porous layer is constituted of a polymer component as a mine component. A combination of electroless plating with electroplating may be used.

As a plating solution used to form the metallic plating layer, solutions of various compositions are known. Solutions sold by manufacturers are available. The composition of the plating solution is not particularly limited, and it is advisable to select the composition in accordance with various desires (such as beautiful appearance, hardness, abrasion resistance, discoloration resistance, corrosion resistance, electroconductivity, thermoconductivity, heat resistance, sliding performance, water repellency, wettability, solder wettability, sealing performance, electromagnetic wave shielding property, and reflectivity).

In the present invention, it is preferred to use a method based on electroless plating as a method for bonding the reactive groups to the metal. It is known that electroless plating is generally useful as a method for layering a metal onto a resin layer made of a plastic or the like. The wiring surface of the layered product may be beforehand subjected to degreasing, washing, neutralizing and catalytic treatments, and/or some other treatment in order to improve the adhesion between the wiring surface and the metal. As the catalytic treatment, use may be made of, for example, a catalytic metal nucleus forming method of causing a catalytic metal capable of promoting the precipitation of a metal to adhere onto the surface to be treated. Examples of the catalytic metal nucleus forming method include a method of bringing an article to be treated into contact with a colloidal solution containing a catalytic metal (salt), and then bringing the article into contact with an acidic or alkaline solution, or a reducing agent to promote chemical plating (the catalyzer/accelerator method) ; and a method of bringing an article to be treated into contact with an acidic or alkaline solution containing a reducing agent, and then bringing the article into contact with an acidic or alkaline solution of a catalytic metal to cause the article to contact the activating liquid, thereby precipitating the catalytic metal (the sensitizing/activating method).

In the catalyzer/accelerator method, the catalytic metal (salt)-containingsolution may be,for example, a tin/palladium mixed solution, or a solution that contains a metal (salt) such as copper sulfate. In the catalyzer/accelerator method, for example, the layered product is immersed in an aqueous solution of copper sulfate, excess copper sulfate is optionally washed to be removed, and then the resultant layered product is immersed in an aqueous solution of sodium borohydride, thereby making it possible to form catalytic nuclei made of fine copper particles onto the wiring surface of the layered product. In the sensitizing/activating method, for example, the layered product is brought into contact with a solution of tin chloride in hydrochloric acid, and the resultant layered product is brought into contact with a solution of palladium chloride in hydrochloric acid, thereby making it possible to precipitate catalytic nuclei made of palladium. The method for bringing the layered product into contact with any one of these treating liquids may be a method of applying the treating liquid onto the layered product surface on which a metallic plating layer is to be formed, a method of immersing the layered product into the treating liquid, or some other method.

The main metal used in electroless plating is, for example, copper, nickel, silver, gold, or nickel-phosphorus. The plating solution used in electroless plating contains, for example, a reducing agent such as formaldehyde, hydrazine, sodium hypophosphite, sodium borohydride, ascorbic acid or glyoxylic acid; a complexing agent or a precipitation controlling agent, such as sodium acetate, EDTA, tartaric acid, malic acid, citric acid or glycine; and some other agent besides any one of the above-mentioned metals or a salt thereof. Many of these agents are sold on the market so as to be easily available. The electroless plating is performed by immersing the above-mentioned treated layered product into the above-mentioned plating solution. Further, when electroless plating is applied to the layered product in the state that a protective sheet is stuck onto one of the surfaces of the layered product, electroless plating is laid only onto the other surface of the layered product; thus, it is possible to prevent the precipitation of any metal onto, for example, the base.

The thickness of the metallic plating layer is not particularly limited, and may be appropriately selected in accordance with the usage of the functional layered product. The thickness is, for example, about 0.01 to 20 $\mu$m, preferably about 0.1 to 10 $\mu$m. In order to make the thickness of the metallic plating layer large efficiently, for example, a method of combining electroless plating with electroplating to form the metallic plating layer may be performed. By conducing more efficient electroplating, a thick metallic plating layer can be obtained in a shorter period.

The above-mentioned method is suitable as a method for yielding a composite material used, in particular, for a circuit substrate, a heat sink, or an electromagnetic wave controlling material.

Furthermore, it is allowable to cover the wiring surface made from a conductive ink with a resin, and use the resultant. The above structure can be preferably used to protect the wiring, insulate the wiring, prevent the wiring from being oxidized or migrated, improve the flexing property thereof, or attain some other purpose. For example, it is feared that silver wiring and copper wiring are oxidized to be turned to silver oxide and copper oxide, respectively, so that the conductivity lowers. However, by covering the wiring surface with the resin, the contact of the wiring with oxygen or moisture can be avoided, so that a fall in the conductivity can be restrained. The method for covering the wiring surface selectively with the resin is, for example, a dropping pipette, a disperser, screen-printing, ink-jetting, or some other method, using a curable resin or a soluble resin that will be described below as the covering resin.

The resin for covering the wiring is not particularly limited, and is, for example, a curable resin usable without any solvent, or a soluble resin usable in the state that the resin is dissolved in a solvent. When the soluble resin is used, it is necessary to cover the wiring surface, considering a decrease in volume when the solvent volatilizes.

Examples of the curable resin include an epoxy resin, an oxetane resin, an acrylic resin, and a vinyl ether resin.

The epoxy resin include various resin species, examples of which are glycidyl ether epoxy resins, such as bisphenol A type, bisphenol F type and other bisphenol type resins, and phenol novolak type, cresol novolak type and other novolak type resins; alicyclic epoxy resins; and modified resins of these resins. As commercially available products of epoxy resins, the following may be used: "ARALDITE" manufactured by Huntsman Advanced Materials, "DENACOL" manufactured by Nagase ChemteX Corporation, "CELLOXIDE" manufactured by Daicel Chemical Industries, Ltd., and "EPOTOHTO" manufactured by Tohto Kasei Co., Ltd. An epoxy resin cured product can be obtained, for example, by a method of mixing a curing agent with an epoxy resin to yield a curable resin composition, starting a curing reaction in the composition, and heating the composition to promote the reaction. The curing agent for the epoxy resin species may be, for example, an organic polyamine, an organic acid, an organic acid anhydride, a phenol compound, a polyamide resin, an isocyanate, or a dicyandiamide.

An epoxy resin cured product can also be obtained by a method of mixing a curing catalyst called a latent curing agent with an epoxy resin to yield a curable resin composition, and heating the composition or radiating light rays such as ultraviolet rays to the composition, thereby starting a curing reaction. As the latent curing agent, commercially available products, such as "SAN-AID SI" manufactured by Sanshin Chemical Industry Co., Ltd. may be used.

When an epoxy resin cured product high in flexibility is used, a flexible article, such as a flexible substrate, can be yielded. When heat resistance or high dimensional stability is required, the use of a composition exhibiting a high hardness after the composition is cured, as the curable resin composition, makes it possible that the functional layered product is used as a rigid substrate (hard substrate).

In a case where an epoxy resin is used for the covering, the curable resin composition is easily handled when the composition is low in viscosity. The composition having this characteristic may be a bisphenol F type composition, or an aliphatic polyglycidyl ether composition.

Examples of the oxetane resin include "ARON OXETANE" manufactured by Toagosei Co., Ltd. An oxetane resin cured product can be obtained by mixing an oxetane resin with, for example, a cationic photopolymerization initiator "IRGACURE 250" manufactured by Ciba Specialty Chemicals Inc., and then radiating ultraviolet rays to the mixture, thereby starting a curing reaction.

As the soluble resin, the following commercially available products may be used: a low dielectric resin "OLIGO PHENYLENE ETHER" manufactured by Mitsubishi Gas Chemical Company, Inc., a polyamideimide resin "VYLOMAX" manufactured by Toyobo Co., Ltd., a polyimide ink "UPICOAT" manufactured by Ube Industries, Ltd., a polyimide ink "EVERLEC" manufactured by Tohto Chemical Industries, a polyimide ink "ULIN COAT" manufactured by NI material, a polyimide ink "Q-PILON" manufactured by PI R&D Co., Ltd., a saturated polyester resin "NICHIGO POLYESTER" manufactured by Nippon Synthetic Chemical Industry Co., Ltd., an acrylic-solvent-type pressure-sensitive adhesive "COPONYL", an ultraviolet/electron-beam curable resin "SHIKOH", and others.

As a solvent in which the soluble resin used at the time of the filling is dissolved, an appropriate solvent may be selected from known organic solvents in accordance with the kind of the resin, and used. As a typical example of a resin solution (soluble resin solution) wherein the soluble resin is dissolved in the solvent, use may be made of a resin solution wherein "OLIGO PHENYLENE ETHER" is dissolved in a general-purpose solvent such as methyl ethyl ketone or toluene; a resin solution wherein "VYLOMAX" is dissolved in an ethanol/toluene mixed solvent (trade name: "HR15ET") ; a resin solution wherein "UPICOAT" is dissolved in triglyme; or some other resin solution.

The method for covering the wiring with the resin is not particularly limited, and may be a method by using a dropping pipette, a spoon, a disperser, screen printing, ink-jetting or some other means to develop (apply) the above-mentioned curable resin composition or the soluble resin solution onto the surface of the transparent layer originating from the porous layer, and optionally removing the excess resin with a spatula or the like. The spatula may be, for example, a spatula made of polypropylene, a fluorine resin such as Teflon (registered trade name), a rubber such as a silicone rubber, or a resin such as polyphenylene sulfide; or a spatula made of a metal such as stainless steel. Among these, a spatula made of a resin is particularly preferred since the spatula does not easily damage the wiring or the transparent layer. Further, without using any spatula or the like, use may be made of a method of dropping an appropriate amount onto the transparent layer surface by use of a means capable of controlling the discharge amount therefrom, such as a dropping pipette, a dispenser, screen printing or ink-jetting.

In order to develop the resin smoothly onto the surface of the transparent layer originating from the porous layer, it is preferred to use, as the resin in an uncured state, a resin low in viscosity. A resin high in viscosity can be made high in handleability by use of the resin in the state that the viscosity is lowered by means of heating the resin at an appropriate temperature. However, when a curable resin is used, the curing reaction rate is raised by heating the resin; thus, heating more intense than necessary unfavorably deteriorates the workability.

After the resin component is developed onto the surface of the transparent layer originating from the porous layer, it is preferred to subject the resulting structure to a heat treatment in order to promote the curing of the resin or volatilize the solvent. The method for the heating is not particularly limited, and is preferably a method of raising the temperature gently since sharp heating may cause the resin or the curing agent to volatilize or cause the solvent to volatilize vigorously so that the resin may become uneven. The temperature may be raised continuously or intermittently. It is preferred to adjust the temperature and the period for the curing and the drying appropriately in accordance with the kind of the resin or the solvent.

Hereinafter, the usages will be specifically described.

An electromagnetic wave controlling material is used as a material that shields or absorbs electromagnetic waves to relieve or restrain an effect produced on the surrounding electromagnetic environment, or an effect that a machine itself receives from the surrounding electromagnetic environment. In the surroundings of us, there are many electromagnetic wave generating sources, such as electrical/electronic instruments, wireless instruments, and systems, for example, spread of digital instruments, personal computers and portable telephones, and these emit various electromagnetic waves. The electromagnetic waves emitted from these instruments may produce an effect onto the surrounding electromagnetic environment, and the instruments themselves are also affected from the surrounding electromagnetic environment. As measures thereagainst, electromagnetic wave controlling materials, such as electromagnetic wave shielding materials or electromagnetic wave absorbent materials, have been increasingly becoming important year after year. The composite material of the present invention can shield electromagnetic waves to give an electromagnetic wave shielding property; and thus, the composite material is very useful as an electromagnetic wave controlling material.

A printed pattern portion that constitutes an electromagnetic wave controlling material has preferably electroconductivity. It is effective that the printed pattern portion is made of, for example, nickel, copper, silver or the like. Further, when the composite material has a layer structure wherein a magnetic plating layer is formed on a printed pattern surface by electroless plating, the composite material is useful as an electromagnetic wave absorbent material. Examples of the material used when the magnetic plating layer is formed by electroless plating include nickel, alloys such as nickel-cobalt, cobalt-iron-phosphorus, cobalt-tungsten-phosphorus and cobalt-nickel-manganese, and other magnetic materials. The present invention can provides the composite material which is a very thin and highly flexible, and the resistance to folding (folding endurance) thereof can be improved. The composite material can be used in the state that the material is fitted or attached to any position of an electronic instrument.

Electromagnetic waves are generated from displays of PDP and others, which are electronic instruments, and the electromagnetic waves produce bad effects (noises) onto the surrounding instruments. In order to prevent (shield) such electromagnetic waves, it is necessary to give an electromagnetic wave shielding function to a filter arranged onto the front surface of a PDP. As the filter, a film wherein wiring in a lattice form is laid is used.

An electromagnetic wave shielding film used for the above-mentioned purpose generally has a structure wherein a metallic layer is layered onto a film having high transparency (highly transparent film). The film can be formed by, for example, a method of laying the metallic layer onto the highly transparent film by sputtering; and a method of laminating a copper foil or the like onto the highly transparent film, and then etching the foil to form a metal mesh; or some other method. An example of the electromagnetic wave shielding film is a film having lines patterned into a lattice form wherein the line width is 20 to 30 $\mu$m and the pitch (each of the recurring intervals) is about 300 $\mu$m.

According to the present invention, an electromagnetic wave shielding film having the above-mentioned structure can be provided by forming wiring in a lattice form onto the porous layer-layered product, and then subjecting the resultant layered product to a heat treatment. At this time, a printing method such as screen printing is used to give wiring to produce the shielding film easily, thereby making it possible to decrease costs.

Furthermore, when an ITO (indium tin oxide) ink, which is a transparent conductor, is used to make printing, the transparency of the wiring portion can also be made higher. Use may be made of, for example, an ITO ink manufactured by C.I. Kasei Co., Ltd., or an ITO ink "NANO-METAL INK" manufactured by ULVAC Materials Inc. The electromagnetic wave film-forming method may be a method of forming wiring by using a zinc oxide ink as another transparent conductor.

In recent years, computer systems have been developed, and a business office PHS, and an in-office wireless LAN have been spreading as communication means. With such situations as a background, needs of electromagnetic wave shielding buildings (intelligent buildings) have been increasingly becoming high, in each of which the whole or a central functional section, as well as the use environment of information instruments, are shielded. In electromagnetic wave shielding buildings, the malfunction of computers, and information leakage are prevented or various noise troubles are prevented so that a good communication environment is maintained.

Electromagnetic wave shielding buildings are realized by 1) using an electromagnetic wave shielding technique for shielding electromagnetic waves, or 2) using an electromagnetic wave absorbing technique for absorbing electromagnetic waves.

A typical material for the electromagnetic wave shielding technique 1) is a metal. Walls, ceilings, floors and other regions of a building are covered with a metal to cause these regions to have electroconductivity, whereby the building can shield electromagnetic waves.

A typical material for the electromagnetic wave absorbing technique 2) is ferrite. By use of ferrite for outside walls of a building in order to prevent electrical radiation interference (ghost), the building can absorb electromagnetic waves.

In an intelligent building, it is necessary to prevent the invasion of electromagnetic waves through windows, doors, ventilation holes and others as openings, and further cause electrical radiation inside the building not to leak outside the building. However, in order to maintain the light transmitting function of the windows, the method 1) or 2) cannot be simply applied to the shielding of the windows. It is necessary to secure sufficient light transmission of the windows and the view through the window, and shield the windows not to spoil the view.

The present invention makes it possible to produce a layered product having a fine conductor pattern on a transparent film. When this transparent film-layered product is stuck onto a window glass sheet, a shielding glass sheet is obtained. The present invention also makes it possible to produce a layered product having a fine conductor pattern on a transparent glass sheet. This transparent glass-layered product can be used as a shielding glass sheet.

In general, circuit substrates have each been produced by a method of laminating a copper foil onto a surface of a base made of a glass/epoxy resin material, polyimide material or some other material, and etching the resultant layered product to remove unnecessary portions of the copper foil, thereby forming wiring. However, according to such a conventional method, it has been becoming difficult to form fine wiring adaptable for circuit substrates the integration degree of which has been made higher. In order to make wiring finer, it is necessary to cause a very thin copper foil piece to adhere closely and strongly onto a substrate made of a glass/epoxy resin material, polyimide material or some other material. However, the thin copper foil piece is very poor in handleability. Thus, very difficult is the step of laminating the thin foil piece onto a substrate. Moreover, the production itself of the thin copper foil is difficult, and high costs are required for the thin copper foil. Furthermore, wiring is formed through the so-called photolithographic step, which is long in time and complicated. Thus, there necessarily remains a problem that costs increase.

Against such a background, with the composite material of the present invention, wiring is formed basically by only printing and the heat treatment; thus, favorably, the wiring-forming step is a very simple step, and the wiring can be produced at low costs.

The porous layer-layered product of the present invention is very useful as a circuit substrate since the porous layer has an excellent printability so that a minute and precise pattern of a conductor can be formed on the porous layer. Furthermore, when the porous layer is heated, thereby being subjected to a treatment for making the layer transparent, an additional value can be further supplied. The method for producing such a circuit substrate may be any method described as the producing method for the above-mentioned composite material including the electromagnetic wave shielding material. According to this method, the porous layer-layered product of the present invention is used; thus, wiring can be easily formed with good precision by use of a printing technique. In a film having a porous layer on a single surface of the base, single-sided wiring can be formed. In a film having porous layers on both surfaces of the base, respectively, double-sided wiring can be formed. When via wiring for connecting both the surfaces to each other is required, the via wiring can be formed by making a hole by means of a conventionally used drill or laser, and filling a conductive paste into the hole or plating the wall of the hole.

In a product obtained by printing a conductor onto the porous layer-layered product of the present invention, and subjecting the resultant layered product to a heat treatment to make the porous layer transparent, fine lines are formed on its light-transmitting base. Thus, such a circuit substrate can be made completely see-through.

Recently, a touch panel has been mounted onto each of many electronic instruments since an excellent user interface can be provided. Examples of the electronic instruments include portable telephones, silicon audio instruments, portable game machines, portable information terminals, and car navigation systems.

Touch panels are classified into many systems. Of these systems, an electrostatic system (an electrostatic capacitance system) is known. As described in "iPhone Fan Book" pp. 38-39 published by Mainichi Communications Inc., a touch panel in an electrostatic system is adopted in the iPhone, which is a portable telephone manufactured by Apple Inc. in the USA. In the touch panel, an X electrode layer and a Y electrode layer, in each of which wiring is formed on a transparent substrate, are used. To such elements can be applied the pattern-formed product of the present invention. It appears that a conductor such as silver can be used by making the width of wiring therefrom small. When an ink of ITO or zinc oxide, which is a transparent conductor, is used to form wiring, the transparency can also be made higher.

In recent years, apprehension has been caused about an energy problem due to the exhaustion of resources and the effect of a remarkable rise in petroleum price, and the problem of global warming based on carbon dioxide generated by the consumption of fossil energies such as coal and petroleum. In this situation, attention has been paid to solar batteries as a reproducible, clean energy source. Examples of solar batteries include monocrystalline silicon type, polycrystalline silicon type, thin-layer amorphous type, and dye sensitizing type solar batteries.

The structure thereof varies, and cannot be specified without reservation. About any cell of solar batteries, an opening therein is required to be made large in order to take sunlight in sufficiently. In order to take out, with good efficiency, electrons generated in the cell by light, it is essential that its electrodes and current collecting wiring are sufficiently fine. The present invention may be applied to such an article, wherein the transparency of a base and fine wiring are required in this way.

The wiring substrate is ordinarily bonded to other parts or substrates through solder, a connector, or the like in order to cause electricity to flow thereto. Thus, it is indispensable that filling with a resin is performed in the state that contact portions thereof are masked, or covering with a resin is performed avoiding the contact portions. The resin may be a curable resin or soluble resin, which has been exemplified above as a resin for covering the wiring.

On the wiring substrate, only wiring may be made; besides, semiconductor chips, condensers, resistors and others may be bonded onto the wiring substrate through solder, wire bonding or the like, as seen in a TAB, a COF or the like. Furthermore, the formation of wiring or mounting of parts may be applied to a single surface of the porous layer-layered product, or may be applied to each surface thereof. By laminating plural substrates onto each other, the wiring substrate may be made into a multilayered structure.

In the composite material of the present invention, a cover layer may be laminated on the transparent layer originating from the porous layer. In the case of, for example, a flexible substrate, its wiring is covered with a covering layer made of a resin film such as a polyimide film or a PET film in many cases in order to protect the wiring, insulate the wiring, prevent the oxidization of the wiring, and improve the flexing property thereof. The covering layer-forming film may be a product "NIKAFLEX" manufactured by The Nikkan Industries Co., Ltd., or a product manufactured by Arisawa Manufacturing Co., Ltd.

The method for laminating the covering layer may be, for example, a method of bonding, under heat and pressure, a covering layer-forming film, such as a polyimide film or a PET film, having a single surface onto which an adhesive is applied, onto the transparent layer originating from the porous layer. The adhesive for the covering layer-forming film may be a known adhesive, and is in a semi-cured state (B stage) in many cases so as to be easily handled.

The covering layer is not necessarily required and the layer may be omitted in a case where only by covering the wiring on the transparent layer originating from the porous layer with a resin, it is possible to protect the wiring, insulate the wiring, prevent the oxidization of the wiring, and ensure the flexing property thereof, sufficiently.

A conductor pattern formed by use of the porous layer-layered product of the present invention may be used as an antenna.

Recently, many wireless instruments have been used, and an antenna is required for transmission and reception of signals. Portable telephones, wireless LANs, IC cards and others have been remarkably spreading. For example, RFID antennas in a loop form are used in IC cards and others. At present, these are formed by the subtractive method (etching method).

By substituting the porous layer-layered product of the present invention for a PET substrate or the like that has been hitherto used, an antenna can be more easily produced. The production method may be similar to a production method for circuit substrate. The subtractive method, which has been hitherto performed, has a long process so as to be a method for which many labors and costs are required. In the same manner as described about the ink-image-receiving sheet, the use of a method of printing an ink containing a conductor to form an antenna makes it possible to produce the antenna more easily at lower costs.

EXAMPLES

Hereinafter, the present invention will be more specifically described by way of examples; however, the present invention is not limited by these examples. Any tape peeling test, average pore diameter, porosity, glass transition temperature, thermal decomposition temperature, and total light transmittance were measured by methods described below.

1. Tape peeling test

(i) A masking tape having a width of 24 mm [Film Masking Tape No. 603 (#25) ] manufactured by Teraoka Seisakusho Co., Ltd. is adhered onto the porous layer surface of a layered product to give an adhered length of 50 mm from one end of the tape; and the adhered tape is bonded thereon under pressure by means of a roller (oil-resistant hard rubber roller No. 10 manufactured by Holbein Art Materials Inc.) having a diameter of 30 mm at a load of 200 gf.
(ii) A universal tensile tester [trade name: "TENSILON RTA-500"] manufactured by Orientec Co., Ltd. is used to pull out the other end of the tape at a peeling speed of 50 mm/minute, thereby performing T-form peeling.
(iii) It was observed whether or not interfacial peeling was generated between the porous layer and the base.

The average pore diameter and the porosity of the porous layer were calculated by a method described below. The average pore diameter and the porosity were obtained using, as objects, only the micropores seen in an electron-microscopic photograph.

2. Average pore diameter

Areas of arbitrary thirty or more pores in a surface or cross section of a layered product were measured from an electron-microscopic photograph. An average value of the measured areas was defined as the average pore area Save. On the assumption that the pores were each a complete round, the average pore area was converted into a pore diameter according to the following equation, and the converted value was defined as the average pore diameter:

$$\text{Average pore diameter } [\mu m] \text{ in the surface or inside}$$
$$= 2 \times (\text{Save}/\pi)^{1/2}$$

wherein $\pi$ represents the ratio of the circumference of a circle to its diameter.

3. Porosity

The porosity inside a porous layer was calculated by the following equation:

$$\text{Porosity } [\%] = 100 - 100 \times W/(\rho \cdot V)$$

wherein V represents the volume [cm$^3$] of the porous layer, W represents the weight [g] of the porous layer, and $\rho$ represents the density [g/cm$^3$] of the porous layer composition,
here, the density of the porous layer composition is calculated by distributing the densities of individual components that constitute the composition in accordance with the composition ratio by weight. The volume V of the porous layer and the weight W of the porous layer were calculated by subtracting, from the volume or the weight of the layered product wherein the porous layer was laminated on the base, the volume or the weight of the base, respectively.
The densities of the individual components in the porous layer composition were as follows:

Density of POLYVINYL BUTYRAL 2400: 1.08 [g/cm$^3$]
Density of poly(vinyl formal), VINYLEC E type: 1.23 [g/cm$^3$]
Density of poly(amide imide), VYLOMAX N-100H: 1.45 [g/cm$^3$]
Density of epoxy resin, jER 828: 1.17 [g/cm$^3$]
Density of cellulose acetate, LT-35: 1.35 [g/cm$^3$]

4. Glass transition temperature

The glass transition temperature of a porous layer composition was measured by use of a differential scanning calorimeter DSC 600E manufactured by Mettler-Toledo. The porous layer-layered product was stored in a desiccator wherein silica gel was put for 24 hours to be dried. The dried porous layer was partially scratched off with a spatula, and this fragment was used as a sample for measurement. The measurement was made basically in accordance with JIS K 7121. The middle-point glass transition temperature (Tmg) obtained from data when the temperature was raised at a first time was deemed as the glass transition temperature mentioned in the present invention.
Concrete measurement conditions were a temperature rise rate of 20°C/min, under a nitrogen atmosphere, and a vessel made of standard aluminum.

5. Thermal decomposition temperature

A sample for measurement was prepared in the same way as in the measurement of the glass transition temperature. In accordance with JIS K 7120, a high-temperature type differential thermal and thermogravimetric simultaneously-measuring meter, "TG/DTA 6300", manufactured by Seiko Instruments Ltd. was used to heat the sample from 25°C to 550°C at a temperature rise rate of 20°C/min under nitrogen stream. Thermogravimetry (TG) for measuring a change in the weight during this period was carried out. In this way, the thermal decomposition temperature of the sample was obtained.

6. Total light transmittance

The total light transmittance (%) was measured in accordance with JIS K7136, using a haze meter, "NDH-5000W" manufactured by Nippon Denshoku Industries Co., Ltd.
First, the total light transmittance (Ts) of the base used itself was measured.
Next, a measurement was made about the total light transmittance (Tsp) of the porous layer-layered product (the base + the porous layer) not subjected to any heat treatment.
Lastly, a measurement was made about the total light transmittance (Tst) of a region of the layered product subjected to the heat treatment so as to be transparent (the base + the transparent layer) that was a region where no wiring was formed.
$$\text{Transparency (T) of the transparent layer} = \left| \text{Total light transmittance (Ts) of the base itself} - \text{Total light transmittance (Tst) of the layered product (the base + the transparent layer)} \right|$$

$$\text{Opaqueness (P) of the porous layer} = \left| \text{the total light transmittance (Ts) of the base itself} - \text{the total light transmittance (Tsp) of the porous layer-layered product (the base + the porous layer)} \right|$$

[Example 1: porous layer-layered product]

A polyvinyl butyral resin solution ("POLYVINYL BUTYRAL 2400" manufactured by Wako Pure Chemical Industries, Ltd. (average polymerization degree: about 2,300 to 2,500); solid content concentration: 15% by weight; solvent: NMP) was prepared, and this was used as a material solution for film-formation. A PET film (S type; thickness: 100 $\mu$m) manufactured by Teijin DuPont Films Japan Limited as a base was fixed onto a glass plate with a tape. This material solution, the temperature of which was set to 25°C, was cast onto the base using a film applicator under a condition that the gap between the film applicator and the base was 76 $\mu$m. Immediately after the casting, the resultant article was kept in a vessel having a humidity of about 100% and a temperature of 50°C for 4 minutes. Thereafter, the article was immersed in water to be coagulated. Next, the article was naturally dried at a room temperature without peeling the cast material from the base, thereby yielding a layered product A wherein a white porous layer was layered on the base. The thickness of the porous layer was about 19 $\mu$m, and the total thickness of the layered product was about 119 $\mu$m. The glass transition temperature of the porous layer portion was measured. As a result, the glass transition temperature was 79.9°C.

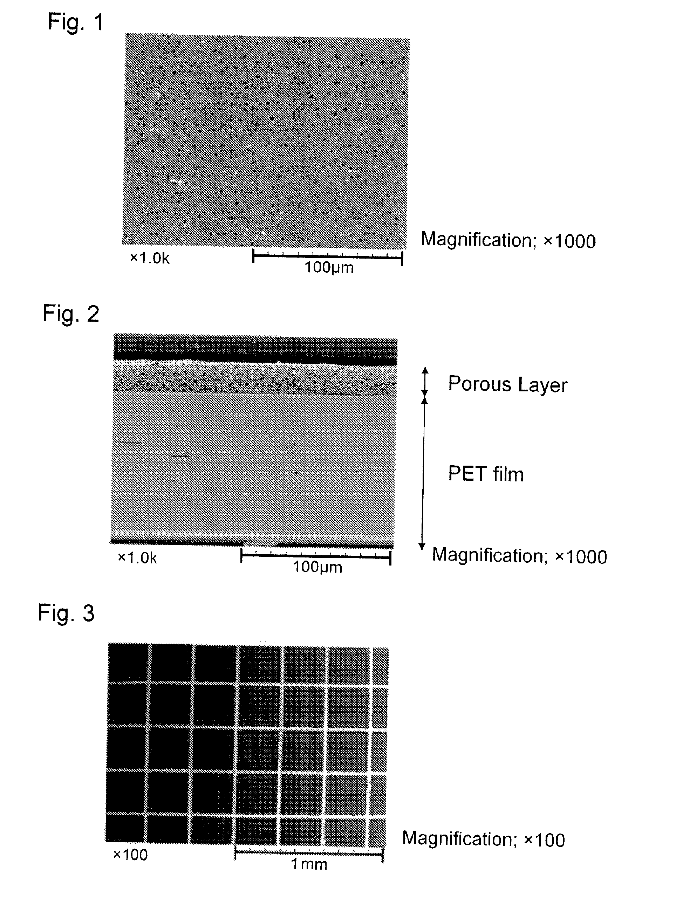

About the obtained layered product A, the tape peeling test was made. As a result, no interfacial peeling was caused between the base and the porous layer. This layered product A was observed with an electron microscope. As a result, the porous layer adhered closely to the PET film, and was substantially homogenous inside thereof, and had micropores having an average pore diameter of about 3 $\mu$m over the whole thereof. The porosity inside the porous layer was 72%. Fig. 1 shows an electron-microscopic photograph of the porous layer surface (with a magnification of 1,000), and Fig. 2 shows an electron-microscopic photograph of a cross section of the layered product (with a magnification of 1,000).

[Example 2: porous layer-layered product]

To 100 parts by weight of a polyvinyl butyral resin solution ("POLYVINYL BUTYRAL 2400" manufactured by Wako Pure Chemical Industries, Ltd. (average polymerization degree: about 2,300 to 2,500); solid content concentration: 15% by weight; solvent: NMP) was added 10 parts by weight of polyethylene glycol 400 (average molecular weight: 360 to 440) manufactured by Wako Pure Chemical Industries, Ltd. as a water-soluble polymer, so as to prepare a material solution for film-formation. A PET film (S type; thickness: 100 $\mu$m) manufactured by Teijin DuPont Films Japan Limited as a base was fixed onto a glass plate with a tape. This material solution, the temperature of which was set to 25°C, was cast onto the base using a film applicator under a condition that the gap between the film applicator and the base was 102 $\mu$m. Immediately after the casting, the resultant article was kept in a vessel having a humidity of about 100% and a temperature of 50°C for 4 minutes. Thereafter, the article was immersed in water to be coagulated. Next, the article was naturally dried at a room temperature without peeling the cast material from the base, thereby yielding a layered product B wherein a white porous layer was layered on the base. The thickness of the porous layer was about 20 $\mu$m, and the total thickness of the layered product was about 120 $\mu$m. The glass transition temperature of the porous layer portion was measured. As a result, the glass transition temperature was 76.9°C.

About the obtained layered product B, the tape peeling test was made. As a result, no interfacial peeling was caused between the base and the porous layer. This layered product B was observed with an electron microscope. As a result, the porous layer adhered closely to the PET film, and was substantially homogenous inside thereof, and had micropores having an average pore diameter of about 2 $\mu$m over the whole thereof. The porosity inside the porous layer was 70%.

[Example 3: porous layer-layered product]

The same operations as in Example 2 were made except that a PET film (trade name: "LUMIRROR T60" manufactured by Toray Industries, Inc.; thickness: 100 $\mu$m) was used instead of the PET film (S type; thickness: 100 $\mu$m) manufactured by Teijin DuPont Films Japan Limited as a base in Example 2, so as to yield a layered product C wherein a white porous layer was layered on the base. The thickness of the resultant porous layer was about 15 $\mu$m, and the total thickness of the layered product was about 115 $\mu$m.

About the obtained layered product C, the tape peeling test was made. As a result, no interfacial peeling was caused between the base and the porous layer. This layered product C was observed with an electron microscope. As a result, the porous layer adhered closely to the PET film, and was substantially homogenous inside thereof, and had micropores having an average pore diameter of about 2 $\mu$m over the whole thereof. The porosity inside the porous layer was 71%.

[Example 4: porous layer-layered product]

The same operations as in Example 2 were made except that a medium-duty glass plate (thickness: 3 mm) was used instead of the PET film (S type; thickness: 100 $\mu$m) manufactured by Teijin DuPont Films Japan Limited as a base in Example 2, so as to yield a layered product D wherein a white porous layer was layered on the base. The thickness of the resultant porous layer was about 19 $\mu$m, and the total thickness of the layered product was about 3019 $\mu$m.

About the obtained layered product D, the tape peeling test was made. As a result, no interfacial peeling was caused between the base and the porous layer. This layered product D was observed with an electron microscope. As a result, the porous layer had micropores having an average pore diameter of about 2 $\mu$m over the whole thereof.

[Example 5: porous layer-layered product]

To 100 parts by weight of a polyvinyl butyral resin solution ("POLYVINYL BUTYRAL 2400" manufactured by Wako Pure Chemical Industries, Ltd. (average polymerization degree: about 2,300 to 2,500); solid content concentration: 15% by weight; solvent: NMP) was added 5 parts by weight of epoxy resin ("jER 828" manufactured by Japan Epoxy Resins Co., Ltd.) as a crosslinking agent, so as to prepare a material solution for film-formation. A PET film (S type;

thickness: 100 µm) manufactured by Teij in DuPont Films Japan Limited as a base was fixed onto a glass plate with a tape. This material solution, the temperature of which was set to 25°C, was cast onto the base using a film applicator under a condition that the gap between the film applicator and the base was 102 µm. Immediately after the casting, the resultant article was kept in a vessel having a humidity of about 100% and a temperature of 50°C for 4 minutes. Thereafter, the article was immersed in water to be coagulated. Next, the article was naturally dried at a room temperature without peeling the cast material from the base, thereby yielding a layered product E wherein a white porous layer was layered on the base. The thickness of the porous layer was about 36 µm, and the total thickness of the layered product was about 136 µm. The glass transition temperature of the porous layer portion was measured. As a result, the glass transition temperature was 49.7°C.

About the obtained layered product E, the tape peeling test was made. As a result, no interfacial peeling was caused between the base and the porous layer. This layered product E was observed with an electron microscope. As a result, the porous layer adhered closely to the PET film, and was substantially homogenous inside thereof, and had micropores having an average pore diameter of about 3 µm over the whole thereof. The porosity inside the porous layer was 68%.

[Example 6: porous layer-layered product]

The same operations as in Example 5 were made except that a PET film (trade name: "LUMIRROR T60" manufactured by Toray Industries, Inc.; thickness: 100 µm) was used instead of the PET film (S type; thickness: 100 µm) manufactured by Teijin DuPont Films Japan Limited as a base in Example 5, so as to yield a layered product F wherein a white porous layer was layered on the base. The thickness of the resultant porous layer was about 25 µm, and the total thickness of the layered product was about 125 µm.

About the obtained layered product F, the tape peeling test was made. As a result, no interfacial peeling was caused between the base and the porous layer. This layered product F was observed with an electron microscope. As a result, the porous layer adhered closely to the PET film, and was substantially homogenous inside thereof, and had micropores having an average pore diameter of about 3 µm over the whole thereof. The porosity inside the porous layer was 68%.

[Example 7: formation of conductive pattern]

A conductive ink [silver paste, NANO DOTITE XA9053, manufactured by Fujikura Kasei Co., Ltd.] was used to print a lattice pattern (line width: 20 µm, and pitch: 300 µm) onto the porous layer surface of the layered product A [the base/the porous layer = the PET film (100 µm) /the polyvinyl butyral (19 µm)] obtained in Example 1, in a screen printing manner under conditions that the printing speed was 15 mm/sec, the printing pressure was 0.1 MPa, and the clearance was 1.5 mm. The used screen printing machine was a machine, LS-150TVA manufactured by Newlong Seimitsu Kogyo Co. , Ltd. The used screen plate was a plate manufactured by Mesh Corporation. After the printing, the resultant layered product was subjected to a heat treatment at 180°C for 30 minutes to cure the conductive ink, thereby forming wiring. The used ink was an ink of a type of reducing silver oxide by heating, so as to be converted to silver. Just after the printing, the ink was black but showed metallic silver gloss after heated. However, the film-contacting portion was kept black. The porous layer, which was white before heated, became transparent. In this way, an electromagnetic wave shielding film was produced. The obtained electromagnetic wave shielding film was observed with an electron microscope. As a result, a conductive pattern in a lattice form was formed wherein the line width was 20 µm, and the pitch was 300 µm. Fig. 3 shows an electron-microscopic photograph of the conductive pattern (with a magnification of 100).

The total light transmittance (Ts) of the PET film (S type; thickness: 100 µm) manufactured by Teijin DuPont Films Japan Limited was 85.8%;
the total light transmittance (Tsp) of the layered product A was 31.9%; and
the total light transmittance (Tst) of the non-wiring region of the layered product made transparent was 87.7%. Accordingly, the transparency (T) of the transparent layer was 1.9%. The opaqueness (P) of the porous layer was 53.9%.

[Example 8: formation of conductive pattern]

The same operations as in Example 7 were made except that the layered product B [the base/the porous layer = the PET film (100 µm) /the polyvinyl butyral (20 µm)] obtained in Example 2 was used as a layered product in Example 7. In this way, a pattern in a lattice form (line width: 20 µm, and pitch: 300 µm) was printed in a screen printing manner, and the resultant layered product was subjected to a heat treatment at 180°C for 30 minutes to produce an electromagnetic wave shielding film. The obtained electromagnetic wave shielding film was observed with an electron microscope. As a result, a conductive pattern in a lattice form was formed wherein the line width was 20 µm, and the pitch was 300 µm.

[Example 9: formation of conductive pattern]

The same operations as in Example 7 were made except that the layered product C [the base/the porous layer = the PET film (100 µm) /the polyvinyl butyral (15 µm)] obtained in Example 3 was used as a layered product in Example 7. In this way, a pattern in a lattice form (line width: 20 µm, and pitch: 300 µm) was printed in a screen printing manner. After the printing, the resultant layered product was subjected to a heat treatment at 150°C for 30 minutes to cure the conductive ink, and subsequently subjected to a heat treatment at 180°C for 30 minutes to make the porous layer transparent. In this way, the heat treatment was conducted at the two stages to produce an electromagnetic wave shielding film. The obtained electromagnetic wave shielding film was observed with an electron microscope. As a result, a pattern in a lattice form was formed wherein the line width was 20 µm, and the pitch was 300 µm.

[Example 10: formation of conductive pattern]

The same operations as in Example 7 were made except that the layered product D [the base/the porous layer = the medium-duty glass plate (3 mm) /the polyvinyl butyral (19 µm) obtained in Example 4 was used as a layered product in Example 7. In this way, a pattern in a lattice form (line width: 20 µm, and pitch: 300 µm) was printed in a screen printing manner, and the resultant layered product was subjected to a heat treatment at 180°C for 30 minutes to produce an electromagnetic wave shielding glass plate. The obtained electromagnetic wave shielding glass plate was observed with an electron microscope. As a result, a pattern in a lattice form was formed wherein the line width was 20 µm, and the pitch was 300 µm.

[Example 11: formation of conductive pattern]

The same operations as in Example 7 were made except that the layered product E [the base/the porous layer = the PET film (100 µm) /the polyvinyl butyral + jER828 (36 µm)] obtained in Example 5 was used as a layered product in Example 7. In this way, a pattern in a lattice form (line width: 20 µm, and pitch: 300 µm) was printed in a screen printing manner, and the resultant layered product was subjected to a heat treatment at 180°C for 30 minutes to produce an electromagnetic wave shielding film. The obtained electromagnetic wave shielding film was observed with an electron microscope. As a result, a pattern in a lattice form was formed wherein the line width was 20 µm, and the pitch was 300 µm.

[Example 12: formation of conductive pattern]

The same operations as in Example 7 were made except that the layered product F [the base/the porous layer = the PET film (100 µm) /the polyvinyl butyral + jER828 (25 µm)] obtained in Example 6 was used as a layered product in Example 7. In this way, a pattern in a lattice form (line width: 20 µm, and pitch: 300 µm) was printed in a screen printing manner, and the resultant layered product was subjected to a heat treatment at 180°C for 30 minutes to produce an electromagnetic wave shielding film. The obtained electromagnetic wave shielding film was observed with an electron microscope. As a result, a pattern in a lattice form was formed wherein the line width was 20 µm, and the pitch was 300 µm.

[Comparative Example 1: formation of conductive pattern]

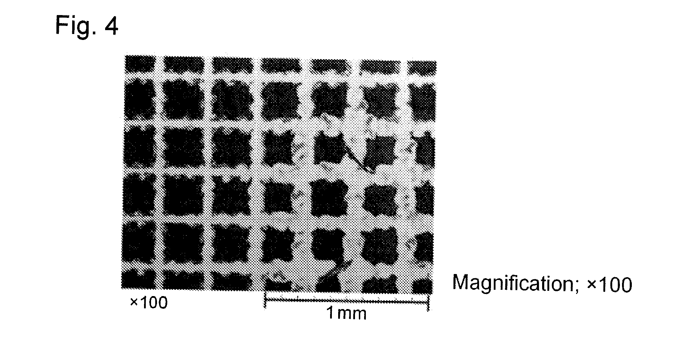

The same operations as in Example 7 were made except that a PET film (S type; thickness: 100 µm) manufactured by Teijin DuPont Films Japan Limited was used as a printing base instead of the layered product A in Example 7. In this way, a pattern in a lattice form (line width: 20 µm, and pitch: 300 µm) was printed directly onto the PET film in a screen printing manner, and the resultant printed film was subjected to a heat treatment at 180°C for 30 minutes to attempt to form an electromagnetic wave shielding film. However, at a single glance of the resultant film, the printing therein was uneven. Furthermore, the resultant printed film was observed with an electron microscope. As a result, the line width varied by points of the film, and was enlarged into a value of about 50 to 150 µm. Thus, the resultant film was unable to be used as an electromagnetic wave shielding film. Fig. 4 shows an electron-microscopic photograph of the conductive pattern (with a magnification of 100).

[Example 13: porous layer-layered product]

A polyvinyl butyral resin solution ("DENKA BUTYRAL #6000-AS" manufactured by DENKI KAGAKU KOGYO KABUSHIKI KAISHA (average polymerization degree: about 2,200); solid content concentration: 15% by weight; solvent: NMP) was prepared, and this was used as a material solution for film-formation. A PET film (S type; thickness: 100 µm) manufactured by Teijin DuPont Films Japan Limited as a base was fixed onto a glass plate with a tape. This material solution, the temperature of which was set to 25°C, was cast onto the base using a film applicator under a condition that the gap between the film applicator and the base was 102 μm. Immediately after the casting, the resultant article was kept in a vessel having a humidity of about 100% and a temperature of 50°C for 4 minutes. Thereafter, the article was immersed in water to be coagulated. Next, the article was naturally dried at a room temperature without peeling the cast material from the base, thereby yielding a layered product G wherein a white porous layer was layered on the base. The thickness of the porous layer was about 16 μm, and the total thickness of the layered product was about 116 μm. The glass transition temperature of the porous layer portion was measured. As a result, the glass transition temperature was 89.8°C.

About the obtained layered product G, the tape peeling test was made. As a result, no interfacial peeling was caused between the base and the porous layer. This layered product G was observed with an electron microscope. As a result, the porous layer adhered closely to the PET film, and was substantially homogenous inside thereof, and had micropores having an average pore diameter of about 2 μm over the whole thereof. The porosity inside the porous layer was 72%.

[Example 14: formation of conductive pattern]

The same operations as in Example 7 were made except that the layered product G [the base/the porous layer = the PET film (100 μm) /the polyvinyl butyral (16 μm) obtained in Example 13 was used as a layered product in Example 7. In this way, a pattern in a lattice form (line width: 20 μm, and pitch: 300 μm) was printed in a screen printing manner, and the resultant layered product was subjected to a heat treatment at 180°C for 30 minutes to produce an electromagnetic wave shielding film. The obtained electromagnetic wave shielding film was observed with an electron microscope. As a result, a conductive pattern in a lattice form was formed wherein the line width was 20 μm, and the pitch was 300 μm.

[Example 15: porous layer-layered product]

The same operations as in Example 13 were made except that a PPS (polyphenylene sulfide) film (trade name: "TORELINA" manufactured by Toray Industries, Inc.; thickness: 50 μm; and its corona-treated-surface was used) was used instead of the PET film (S type; thickness: 100 μm) manufactured by Teijin DuPont Films Japan Limited as a base in Example 13, so as to yield a layered product H wherein a white porous layer was layered on the base. The thickness of the resultant porous layer was about 17 μm, and the total thickness of the layered product was about 117 μm.

About the obtained layered product H, the tape peeling test was made. As a result, no interfacial peeling was caused between the base and the porous layer. This layered product H was observed with an electron microscope. As a result, the porous layer adhered closely to the PPS film, and was substantially homogenous inside thereof, and had micropores having an average pore diameter of about 2 μm over the whole thereof. The porosity inside the porous layer was 71%.

[Example 16: formation of conductive pattern]

The same operations as in Example 7 were made except that the layered product H [the base/the porous layer = the PPS film (50 μm) /the polyvinyl butyral (17 μm)] obtained in Example 15 was used as a layered product in Example 7. In this way, a pattern in a lattice form (line width: 20 μm, and pitch: 300 μm) was printed in a screen printing manner, and the resultant layered product was subjected to a heat treatment at 180°C for 30 minutes to produce an electromagnetic wave shielding film. The obtained electromagnetic wave shielding film was observed with an electron microscope. As a result, a conductive pattern in a lattice form was formed wherein the line width was 20 μm, and the pitch was 300 μm.

[Example 17: porous layer-layered product]

The same operations as in Example 13 were made except that the following was used as a base: a product wherein a polyimide film, KAPTON 200H (thickness: 50 μm) manufactured by DuPont-Toray Co., Ltd. was caused to adhere onto a pressure-sensitive adhesive layer surface of a PEN film pressure-sensitive adhesive tape (trade name: "635F #25"; PEN thickness: 25 μm; and pressure-sensitive adhesive layer thickness: 30 μm) manufactured by Teraoka Seisakusho Co., Ltd. instead of the PET film (S type; thickness: 100 μm) manufactured by Teijin DuPont Films Japan Limited in Example 13. In this way, a layered product I wherein a white porous layer was layered on the PEN surface of the base was yielded. The thickness of the resultant porous layer was about 20 μm, and the total thickness of the layered product was about 120 μm.

About the obtained layered product I, the tape peeling test was made. As a result, no interfacial peeling was caused between the base and the porous layer. This layered product I was observed with an electron microscope. As a result, the porous layer adhered closely to the PEN film, and was substantially homogenous inside thereof, and had micropores having an average pore diameter of about 2 μm over the whole thereof. The porosity inside the porous layer was 71%.

[Example 18: formation of conductive pattern]

The same operations as in Example 7 were made except that the layered product I [the base/the porous layer = the PEN film pressure-sensitive adhesive tape (25 $\mu$m) + the adhesive layer (30 $\mu$m) + the polyimide film (50 $\mu$m) /the polyvinyl butyral (20 $\mu$m)] obtained in Example 17 was used as a layered product in Example 7. In this way, a pattern in a lattice form (line width: 20 $\mu$m, and pitch: 300 $\mu$m) was printed in a screen printing manner, and the resultant layered product was subjected to a heat treatment at 180°C for 30 minutes to produce an electromagnetic wave shielding film. The obtained electromagnetic wave shielding film was observed with an electron microscope. As a result, a conductive pattern in a lattice form was formed wherein the line width was 20 $\mu$m, and the pitch was 300 $\mu$m.

[Example 19: porous layer-layered product]

A polyvinyl formal resin solution ("VINYLEC E TYPE" manufactured by CHISSO CORPORATION (molecular weight:95,000-134,000); solid content concentration: 15% by weight; solvent: NMP) was prepared, and this was used as a material solution for film-formation. A PET film (S type; thickness: 100 $\mu$m) manufactured by Teijin DuPont Films Japan Limited as a base was fixed onto a glass plate with a tape. This material solution, the temperature of which was set to 25°C, was cast onto the base using a film applicator under a condition that the gap between the film applicator and the base was 102 $\mu$m. Immediately after the casting, the resultant article was kept in a vessel having a humidity of about 100% and a temperature of 50°C for 4 minutes. Thereafter, the article was immersed in water to be coagulated. Next, the article was naturally dried at a room temperature without peeling the cast material from the base, thereby yielding a layered product J wherein a white porous layer was layered on the base. The thickness of the porous layer was about 16 $\mu$m, and the total thickness of the layered product was about 116 $\mu$m. The glass transition temperature of the porous layer portion was measured. As a result, the glass transition temperature was 93.2°C.
About the obtained layered product J, the tape peeling test was made. As a result, no interfacial peeling was caused between the base and the porous layer. This layered product J was observed with an electron microscope. As a result, the porous layer adhered closely to the PET film, and was substantially homogenous inside thereof, and had micropores having an average pore diameter of about 1.5 $\mu$m over the whole thereof. The porosity inside the porous layer was 70%.

[Example 20: formation of conductive pattern]

The same operations as in Example 7 were made except that the layered product J [the base/the porous layer = the PET film (100 $\mu$m) /the polyvinyl formal (16 $\mu$m)] obtained in Example 19 was used as a layered product in Example 7. In this way, a pattern in a lattice form (line width: 20 $\mu$m, and pitch: 300 $\mu$m) was printed in a screen printing manner, and the resultant layered product was subjected to a heat treatment at 180°C for 30 minutes to produce an electromagnetic wave shielding film. The obtained electromagnetic wave shielding film was observed with an electron microscope. As a result, a conductive pattern in a lattice form was formed wherein the line width was 20 $\mu$m, and the pitch was 300 $\mu$m.

[Example 21: porous layer-layered product]

A material solution for film-formation was prepared by mixing a polyamideimide resin solution (trade name: "VYLOMAX N-100H", manufactured by Toyobo Co., Ltd.; solid content concentration: 20% by weight; solvent: NMP; and solution viscosity: 350 dPa·s/25°C), NMP as a solvent, a polyvinyl pyrrolidone (molecular weight: 10,000) manufactured by Aldrich as a water-soluble polymer, and a bisphenol A type epoxy resin (trade name: "jER 828" manufactured by Japan Epoxy Resins Co., Ltd.) as a crosslinking agent with each other to set the ratio by weight of the polyamideimide resin/NMP/the polyvinyl pyrrolidone/the bisphenol A type epoxy resin to 15/85/25/10. A polyimide film (trade name: "KAPTON 200H" manufactured by DuPont-Toray Co., Ltd.; thickness: 50 $\mu$m) as a base was fixed onto a glass plate with a tape. This material solution, the temperature of which was set to 25°C, was cast onto the base using a film applicator under a condition that the gap between the film applicator and the base was 51 $\mu$m. Immediately after the casting, the resultant article was kept in a vessel having a humidity of about 100% and a temperature of 50°C for 4 minutes. Thereafter, the article was immersed in water to be coagulated. Next, the article was naturally dried at a room temperature without peeling the cast material from the base, thereby yielding a layered product K wherein a porous layer was layered on the base. The thickness of the porous layer was about 23 $\mu$m, and the total thickness of the layered product was about 73 $\mu$m.
The glass transition temperature of the porous layer portion was measured. As a result, in the DSC, endothermic process corresponding to the glass transition temperature was not observed up to 160°C. However, large exothermic process having a peak of 202°C was observed from 160°C to 280°C, which appeared to be caused by a crosslinking reaction. Any other endothermic process as well as any other exothermic process were not recognized from 280°C to 300°C. About the porous layer composition of Example 21, it was presumed that the polyamideimide resin was made plastic by the crosslinking agent and the composition of Example 21 had a lower glass transition temperature than the glass transition temperature (287°C) of the porous layer composition obtained in Comparative Example 4 that will be described later, wherein no crosslinking agent was added. Considering the above DSC results, it appeared that the composition of Example 21 had a glass transition temperature in the range of 160°C to 280°C. In the DSC, due to the exotherm by a crosslinking reaction, the glass transition temperature was unable to be directly measured.

About the obtained layered product K, the tape peeling test was made. As a result, no interfacial peeling was caused between the base and the porous layer. This layered product K was observed with an electron microscope. As a result, the porous layer adhered closely to the polyimide film, and was substantially homogenous inside thereof, and had interconnecting micropores having an average pore diameter of about 0.5 $\mu$m over the whole thereof. The porosity inside the porous layer was 76%.

[Example 22: formation of a conductive pattern]

A conductive ink [silver paste, NANO DOTITE XA9053, manufactured by Fujikura Kasei Co., Ltd.] was used to print a lattice pattern (line width: 20 $\mu$m, and pitch: 300 $\mu$m) onto the porous layer surface of the layered product K [the base/the porous layer = the polyimide film (50 $\mu$m) /the polyamideimide resin + jER 828 (23 $\mu$m)] obtained in Example 21 in a screen printing manner under conditions that the printing speed was 15 mm/sec, the printing pressure was 0.1 MPa, and the clearance was 1.5 mm. The used screen printing machine was a machine, LS-150TVA manufactured by Newlong Seimitsu Kogyo Co., Ltd. The used screen plate was a plate manufactured by Mesh Corporation. After the printing, the resultant layered product sample was subjected to a heat treatment on a hot plate, the temperature of which was set to 200°C, for 30 minutes to cure the conductive ink, thereby forming wiring. In the heat treatment, the sample was heated in the state that the sample was covered with a vat made of aluminum and having a depth of about 20 mm from above so as to heat the whole of the sample uniformly. The used ink was an ink of a type of reducing silver oxide by heating, so as to be converted to silver. Just after the printing, the ink was black but showed metallic silver gloss after heated. However, the film-contacting portion was kept black. The porous layer, which was yellowish white before heated, became transparent. In this way, an electromagnetic wave shielding film was produced. The obtained electromagnetic wave shielding film was observed with an electron microscope. As a result, a conductive pattern in a lattice form was formed wherein the line width was 20 $\mu$m, and the pitch was 300 $\mu$m.

The total light transmittance (Ts) of the polyimide film (trade name: "KAPTON 200H", manufactured by DuPont-Toray Co., Ltd.; thickness: 50 $\mu$m) was 41.0%;

the total light transmittance (Tsp) of the layered product K was 8.1%; and

the total light transmittance (Tst) of the non-wiring region of the layered product made transparent was 38.1%.

Accordingly, the transparency (T) of the transparent layer was 2.9%. The opaqueness (P) of the porous layer was 32.9%.

[Comparative Example 2: porous layer-layered product]

An material solution for film-formation was prepared by mixing a polyamideimide resin solution (trade name: "VYLOMAX N-100H", manufactured by Toyobo Co., Ltd.; solid content concentration: 20% by weight; solvent: NMP; and solution viscosity: 350 dPa·s/25°C), NMP as a solvent, and a polyvinyl pyrrolidone (molecular weight: 10,000) manufactured by Aldrich as a water-soluble polymer with each other to set the ratio by weight of the polyamideimide resin/NMP/the polyvinyl pyrrolidone to 15/85/25. A polyimide film (trade name: "KAPTON 200H" manufactured by DuPont-Toray Co., Ltd.; thickness: 50 $\mu$m) as a base was fixed onto a glass plate with a tape. This material solution, the temperature of which was set to 25°C, was cast onto the base using a film applicator under a condition that the gap between the film applicator and the base was 51 $\mu$m. Immediately after the casting, the resultant article was kept in a vessel having a humidity of about 100% and a temperature of 50°C for 4 minutes. Thereafter, the article was immersed in water to be coagulated. Next, the article was naturally dried at a room temperature without peeling the cast material from the base, thereby yielding a layered product wherein a porous layer was layered on the base. The thickness of the porous layer was about 22 $\mu$m, and the total thickness of the layered product was about 72 $\mu$m.

The glass transition temperature of the porous layer portion was measured. As a result, the glass transition temperature was 287°C. In the thermogravimetry (TG), a reduction in the weight started from 300°C, and an abrupt reduction in the weight was recognized from 340°C. Thus, it was verified that the porous layer started to be gradually deteriorated by the heating at 300°C or higher and the porous layer was completely decomposed at 340°C or higher.

About the obtained layered product, the tape peeling test was made. As a result, no interfacial peeling was caused between the base and the porous layer. This layered product was observed with an electron microscope. As a result, the porous layer adhered closely to the polyimide film, and was substantially homogenous inside thereof, and had interconnecting micropores having an average pore diameter of about 0.5 $\mu$m over the whole thereof. The porosity inside the porous layer was 72%.

[Comparative Example 3: formation of conductive pattern]

The same operations as in Example 7 were made except that the layered product obtained in Comparative Example 2 [the base/the porous layer = the polyimide film (50 $\mu$m) /the polyamideimide resin (22 $\mu$m)] was used as a layered product in Example 7. In this way, a pattern in a lattice form (line width: 20 $\mu$m, and pitch: 300 $\mu$m) was printed in a screen printing manner. The resultant layered product sample was subjected to a heat treatment on a hot plate, the temperature of which was set to 200°C, for 30 minutes to produce an electromagnetic wave shielding film. In the heat treatment, the sample was heated in the state that the sample was covered with a vat made of aluminum and having a depth of about 20 mm from above so as to heat the whole of the sample uniformly. The obtained electromagnetic wave shielding film was observed with an electron microscope. As a result, a conductive pattern in a lattice form was formed wherein the line width was 20 $\mu$m, and the pitch was 300 $\mu$m. However, even by the heat treatment at 200°C for 30 minutes after the printing, the porous layer was not made transparent, and the color thereof was kept yellowish white, which was not substantially changed from the color before the heat treatment.
The total light transmittance (Ts) of the polyimide film (trade name: "KAPTON 200H", manufactured by DuPont-Toray Co., Ltd.; thickness: 50 $\mu$m) was 41.0%;
the total light transmittance (Tsp) of the layered product obtained in Comparative Example 2 was 8.2%; and the total light transmittance (Tst) of the non-wiring region of the layered product after the heat treatment was 8.1%. Accordingly, the transparency (T) after the heat treatment was 32.90. The opaqueness (P) of the porous layer before the heat treatment was 32.8%.

[Comparative Example 4: formation of conductive pattern]

The same operations as in Comparative Example 3 were made except that the heat treatment conditions after the printing in Comparative Example 3 were changed to a heat treatment on a hot plate the temperature of which was set to 300°C of 30 minutes. In this way, an electromagnetic wave shielding film was produced. The obtained electromagnetic wave shielding film was observed with an electron microscope. As a result, a conductive pattern in a lattice form was formed wherein the line width was 20 $\mu$m, and the pitch was 300 $\mu$m. However, the porous layer was not made transparent, and the following phenomenon was observed: a deterioration phenomenon that the yellowish white was discolored into ocher.
The total light transmittance (Ts) of the polyimide film (trade name: "KAPTON 200H", manufactured by DuPont-Toray Co., Ltd.; thickness: 50 $\mu$m) was 41.0%;
the total light transmittance (Tsp) of the layered product obtained in Comparative Example 2 was 8.2%; and
the total light transmittance (Tst) of the non-wiring region of the layered product after the heat treatment was 4.3%. Accordingly, the transparency (T) after the heat treatment was 36.7%. The opaqueness (P) of the porous layer before the heat treatment was 32.8%.

**Claims**

1.  A layered product comprising a base and a porous layer on at least one surface of the base, wherein
    the porous layer is constituted of a composition containing a polymer as a main component,
    the porous layer has micropores having an average pore diameter of 0.01 to 10 $\mu$m, and has a porosity of 30 to 85%,
    the composition constituting the porous layer has a glass transition temperature of 20°C or higher, and the porous layer is a layer which is convertible to a transparent layer by a heat treatment through disappearance of the micropores.

2.  The layered product according to claim 1, wherein the base is a light-transmitting base selected from the group consisting of a transparent resin film, a transparent glass plate, and a transparent ceramic substrate.

3.  The layered product according to claim 1, wherein the composition, which constitutes the porous layer, further contains a crosslinking agent and/or a plasticizer.

4.  The layered product according to claim 1, wherein the porous layer is a layer formed by:

    casting a solution of a porous layer-forming material containing the polymer which is to constitute the porous layer into a film form onto the base; and then
immersing the resultant cast film in a coagulating liquid; and then
drying the resultant structure.

5. The layered product according to claim 11, wherein at least one selected from the group consisting of a conductor layer, a dielectric layer, a semiconductor layer, an insulator layer, a resistor layer, and a precursor layer of any one of these layers is/are further formed on the surface of the porous layer by a printing technique.

6. A process for producing the layered product according to claim 1, comprising:

casting a solution of a porous layer-forming material containing a polymer which is to constitute the porous layer into a film form onto the base; and then
immersing the resultant cast film in a coagulating liquid; and then
drying the resultant structure.

7. The process for producing the layered product according to claim 6, wherein the solution of the porous layer-forming material is cast into the film form onto the base, and then the resultant cast film is kept in an atmosphere having a relative humidity of 70 to 100% and a temperature of 15 to 100°C for 0.2 to 15 minutes, and then the resultant cast film is immersed in the coagulating liquid.

8. A process for converting the porous layer to a transparent layer, comprising:

subjecting the layered product according to claim 1 to a heat treatment at a temperature that is the glass transition temperature of the composition constituting the porous layer or higher to cause the micropores in the porous layer to disappear.

9. A process for producing a functional layered product comprising a base, a transparent layer containing a polymer as a main component on the base, and a functional layer formed on the transparent layer and selected from the group consisting of a conductor layer, a dielectric layer, a semiconductor layer, an insulator layer, and a resistor layer, the process comprising:

forming, on the surface of the porous layer of the layered product according to claim 1, a layer selected from the group consisting of the conductor layer, the dielectric layer, the semiconductor layer, the insulator layer, the resistor layer, and a precursor layer of these layers; and
subjecting the resultant layered product to a heat treatment at a temperature that is the glass transition temperature of the composition constituting the porous layer or higher to cause the micropores in the porous layer to disappear, thereby converting the porous layer to a transparent layer.

10. The process for producing the functional layered product according to claim 9, wherein the functional layer is patterned.

11. A functional layered product comprising a base, a transparent layer containing a polymer as a main component on the base, and a functional layer formed on the transparent layer and selected from the group consisting of a conductor layer, a dielectric layer, a semiconductor layer, an insulator layer, and a resistor layer, wherein the functional layered product is obtained by:

forming, on the surface of the porous layer of the layered product according to claim 1, a layer selected from the group consisting of the conductor layer, the dielectric layer, the semiconductor layer, the insulator layer, the resistor layer, and a precursor layer of these layers; and
subjecting the resultant layered product to a heat treatment at a temperature that is the glass transition temperature of the composition constituting the porous layer or higher to cause the micropores in the porous layer to disappear, thereby converting the porous layer to a transparent layer.

12. The functional layered product according to claim 11, wherein the functional layer is patterned.

Fig. 1

×1.0k    100μm    Magnification; ×1000

Fig. 2

Porous Layer

PET film

×1.0k    100μm    Magnification; ×1000

Fig. 3

×100    1mm    Magnification; ×100

Fig. 4

×100

1 mm

Magnification; ×100

**INTERNATIONAL SEARCH REPORT**

| International application No. |
| --- |
| PCT/JP2009/060546 |

A. CLASSIFICATION OF SUBJECT MATTER
*B32B5/18*(2006.01)i, *B32B7/02*(2006.01)i, *B32B37/06*(2006.01)i, *C08J9/28*
(2006.01)i

According to International Patent Classification (IPC) or to both national classification and IPC

B. FIELDS SEARCHED

Minimum documentation searched (classification system followed by classification symbols)
B32B1/00-43/00, C08J9/00-9/42, H05K3/00, H05K1/03

Documentation searched other than minimum documentation to the extent that such documents are included in the fields searched
Jitsuyo Shinan Koho           1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)
JSTPlus/JST7580(JDreamII)

C. DOCUMENTS CONSIDERED TO BE RELEVANT

| Category* | Citation of document, with indication, where appropriate, of the relevant passages | Relevant to claim No. |
| --- | --- | --- |
| X<br>A | WO 2007/097249 A1 (Daicel Chemical Industries, Ltd.),<br>30 August, 2007 (30.08.07),<br>Claims 1, 3, 6, 14, 18, 19, 26, 77; Par. Nos. [0048], [0062], [0067] to [0070], [0127], [0267], [0329], [0330], [0341], [0351], [0354], [0355], [0434], [0435]<br>& US 2009/0008142 A1     & EP 1995053 A1<br>Claims 1, 3, 6, 14, 18, 19, 26, 77; Par. Nos. [0049], [0063], [0068] to [0071], [0128], [0268], [0330], [0331], [0342], [0352], [0355], [0356], [0435], [0436]<br>& KR 10-2009-0003249 A   & CN 101384425 A | 1-7<br>8-12 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>07 August, 2009 (07.08.09) | Date of mailing of the international search report<br>18 August, 2009 (18.08.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| International application No. |
| --- |
| PCT/JP2009/060546 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | WO 2005/030849 A1  (Daicel Chemical Industries, Ltd.), 07 April, 2005 (07.04.05), Full text & US 2007/0036959 A1    & EP 1672011 A1 & KR 10-2006-0099514 A   & CN 1856533 A | 1-12 |
| A | JP 2005-162885 A  (Daicel Chemical Industries, Ltd.), 23 June, 2005 (23.06.05), Full text (Family: none) | 1-12 |
| A | JP 2001-145826 A  (Ube Industries, Ltd.), 29 May, 2001 (29.05.01), Full text (Family: none) | 1-12 |
| P,A | JP 2009-73124 A  (Daicel Chemical Industries, Ltd.), 09 April, 2009 (09.04.09), Full text (Family: none) | 1-12 |

Form PCT/ISA/210 (continuation of second sheet) (April 2007)

**REFERENCES CITED IN THE DESCRIPTION**

**Patent documents cited in the description**

- JP 2003313356 A
- JP 2005162885 A
- JP 2007126638 A
- JP 2007246876 A
- JP 1278800 A

- JP 5323101 A
- JP 5327274 A
- JP 5269912 A
- JP 3388682 B
- WO 2007097249 A

**Non-patent literature cited in the description**

- *Nikkei Electronics,* 2002, vol. 6 (17), 75

- iPhone Fan Book. Mainichi Communications Inc, 38-39